(19) Europäisches Patentamt
European Patent Office
Office européen des brevets

(11) **EP 1 728 278 B1**

(12) **EUROPÄISCHE PATENTSCHRIFT**

(45) Veröffentlichungstag und Bekanntmachung des Hinweises auf die Patenterteilung:
**19.10.2011 Patentblatt 2011/42**

(51) Int Cl.:
*H01L 23/473* (2006.01)   *H01L 23/367* (2006.01)
*H05K 7/20* (2006.01)

(21) Anmeldenummer: 05716026.9

(22) Anmeldetag: **14.03.2005**

(86) Internationale Anmeldenummer:
**PCT/EP2005/002680**

(87) Internationale Veröffentlichungsnummer:
**WO 2005/093830 (06.10.2005 Gazette 2005/40)**

(54) **WÄRMETAUSCHER**

HEAT EXCHANGER

ECHANGEUR DE CHALEUR

(84) Benannte Vertragsstaaten:
**AT BE BG CH CY CZ DE DK EE ES FI FR GB GR HU IE IS IT LI LT LU MC NL PL PT RO SE SI SK TR**

(30) Priorität: 26.03.2004 DE 202004005241 U
27.11.2004 DE 202004019084 U
15.12.2004 DE 202004019852 U

(43) Veröffentlichungstag der Anmeldung:
**06.12.2006 Patentblatt 2006/49**

(73) Patentinhaber: **ebm-papst St. Georgen GmbH & Co. KG**
**78112 St. Georgen (DE)**

(72) Erfinder:
• **LAUFER, Wolfgang**
**78733 Aichhalden (DE)**
• **ANGELIS, Walter, Georg**
**89567 Sontheim (DE)**
• **SEIDLER, Siegfried**
**78056 Villingen-Schwenningen (DE)**
• **WEISSER, Norbert**
**78078 Niedereschach-Kappel (DE)**
• **THREN, Christian**
**74177 Bad Friedrichshall (DE)**

(74) Vertreter: **Raible, Tobias**
**Raible & Raible**
**Schoderstrasse 10**
**70192 Stuttgart (DE)**

(56) Entgegenhaltungen:
**EP-A- 0 560 259    EP-A- 1 204 143**
**US-A- 4 494 171    US-A- 5 070 936**
**US-A- 5 263 536    US-A- 5 365 400**

• **PATENT ABSTRACTS OF JAPAN Bd. 018, Nr. 629 (E-1637), 30. November 1994 (1994-11-30) -& JP 06 244575 A (PFU LTD), 2. September 1994 (1994-09-02)**

**Beschreibung**

Die Erfindung betrifft einen Wärmeaufnehmer (heat sink) zur Aufnahme und Abfuhr von Wärme aus einem Leistungsbauteil, z.B. einem Mikroprozessor, einem Mikrocontroller, einem ASIC oder dergleichen. Die Erfindung eignet sich in gleicher Weise für die Kühlung von Leistungsbauteilen mit hoher Wärmestromdichte (heat flux density).

Bauteile der Leistungselektronik, welche gekühlt werden müssen, dürfen sich nicht über bestimmte Grenztemperaturen hinaus erwärmen. Da zudem durch die Verringerung der Leiterbreite die Oberfläche von Prozessoren oder sonstigen Bauteilen immer kleiner wird, ergibt sich ein starker Anstieg der Dichte des abzuleitenden Wärmestroms, also der Wärmestromdichte. Dies macht es schwieriger, das Prinzip der so genannten Wärmespreizung anzuwenden. Denn Bereiche innerhalb eines Wärmeaufnehmers, welche von dem Bauteil entfernt sind, das gekühlt werden soll, können nur dann zur Wärmeübertragung effektiv beitragen, wenn ihre Temperatur signifikant höher liegt als die Temperatur des an ihnen vorbei strömenden Kühlfluids. Auch müssen die Strömungsgeschwindigkeiten hinreichend groß und folglich die thermischen Grenzschichten hinreichend dünn sein, um effektiv Wärme ableiten zu können.

Aus der US 5 263 536 kennt man einen Miniatur-Wärmetauscher zum Entziehen von Wärme von Laserdioden oder Spiegelsegmenten. Diese Teile werden zum Entziehen der Wärme auf einer ebenen äußeren Kühlfläche eines hohlen Bauteils montiert, das auf der Innenseite mit zur äußeren Kühlfläche ragenden Nuten versehen ist, wobei die Bereiche zwischen den Nuten von der Kühlfläche weg ragen. Eine Basisplatte hat eine Wassereinlassöffnung zur Zufuhr von Wasser und eine Wasserauslassöffnung zur Abfuhr von Wasser. Die Nuten auf der Innenseite der Kühlfläche werden von einem als "Duschkopf" bezeichneten Bauteil mit Wasser besprüht, um der Kühlfläche durch Erwärmung des Wassers Wärme zu entziehen. Das erwärmte Wasser strömt im Inneren des hohlen Bauteils zu der Basisplatte aus Messing und von dieser zur Wasserauslassöffnung.

Aus der US 5 070 936 kennt man eine Kühlplatte, auf deren Vorderseite eine zu kühlende Laserdiode befestigt ist und deren Rückseite mit Kühlstiften versehen ist. Der zentrale Bereich dieser Kühlstifte wird aus einer Düsenplatte, welche gegen diese Kühlstifte anliegt, mit Kühlflüssigkeit versorgt. Über eine zentrale Zufuhrleitung wird die Kühlflüssigkeit der Düsenplatte zugeführt. Die erwärmte Kühlflüssigkeit wird über eine Leitung abgeführt, welche koaxial zur zentralen Zufuhrleitung verläuft.

Aus der JP 06/244 575 A kennt man eine Wärmesenke, die mit Kühlstiften versehen ist. Ihr gegenüber befindet sich ein Axiallüfter, der Luft auf diese Kühlstifte bläst, wobei freilich der zentrale Bereich der Wärmesenke wenig Kühlluft erhält, da ihr der Motor des Lüfters gegenüber liegt. Für die Form und Anordnung der Kühlstifte sind verschiedene Varianten angegeben.

Es ist eine Aufgabe der Erfindung, einen neuen Wärmetauscher bereit zu stellen.

Der Wärmeaufnehmer nach der vorliegenden erfindung ist durch des Anspruch 1 definiert.

Durch die. Erfindung erhält man einen Wärmeaufnehmer, der im Betrieb von einem Kühlfluid durchströmt wird und ein hohes Oberflächenangebot aufweist. In ihm trifft kaltes Kühlfluid zunächst auf Regionen mit hohen absoluten Temperaturen. Dabei kann in vorteilhafter Weise weitgehend verhindert werden, dass sich Kühlfluid, das sich bereits erwärmt hat, mit frischem, kaltem Kühlfluid durchmischt, bevor letzteres auf Regionen mit den höchsten absoluten Temperaturen trifft. Auch können die Regionen mit den höchsten absoluten Temperaturen mit hohen Strömungsgeschwindigkeiten des Kühlfluids angeströmt werden, um dort eine turbulente Strömung und folglich eine optimale Wärmeübertragung zu erhalten.

Zu diesem Zweck sind in einer muldenförmigen Vertiefung eine Mehrzahl von Wärmeleitelementen angeordnet, welche vom Boden dieser Vertiefung in den Weg des Kühlfluids ragen, wodurch sie im Betrieb von diesem umströmt werden. Das ergibt eine entsprechende Vergrößerung der Wärme übertragenden Oberflächen. Die Wärmeleitelemente und ihre Zwischenräume haben bevorzugt Abmessungen, die mit wirtschaftlichen Verfahren gefertigt werden können, z.B. durch Fräsen, Erosionsverfahren, Gießverfahren, Umformen, Prägen, Pressen, etc. Es hat sich auch gezeigt, dass man durch eine geeignete Oberflächenbehandlung, bevorzugt durch Sandstrahlen, die Wärmeübertragung auf das Kühlfluid günstig beeinflussen kann.

Man kann die Umrissform der muldenförmigen Vertiefung, die man auch als konkave Konfiguration oder als Kavität bezeichnen kann, an die Bedürfnisse eines zu kühlenden Substrats anpassen. Z.B. ist eine Kavität in Form einer Kugelkalotte durch Fräsen leicht herstellbar. Alternativ können Rotations-Kegelschnitte verwendet werden, z.B. eine Kavität in Form eines Rotations-Paraboloids oder dergleichen.

Das Gehäuse eines solchen Wärmeaufnehmers kann Befestigungsmöglichkeiten aufweisen, mit denen das Gehäuse an bereits vorhandene Befestigungspunkte anmontiert werden kann.

In bevorzugter Weise hat das Einlasselement an seinem Auslass ein Düsenfeld, welches z.B. Runddüsen oder Schlitzdüsen aufweisen kann. Beim Durchströmen eines solchen Düsenfelds wird das Kühlfluid beschleunigt. Dadurch trifft das kalte Kühlfluid mit hoher Geschwindigkeit auf Regionen mit hohen absoluten Temperaturen.

Durch das Düsenfeld kann auch erreicht werden, dass ein Teil des Kühlfluids bei Durchströmen des Düsenfelds abgelenkt wird, was man als ein Ergebnis des so genannten Coanda-Effekts (so genannt nach Henry Coanda) bezeichnen kann. Durch die Ausnutzung dieses Effekts können Teile des kalten Kühlfluids gezielt auf weiter außen liegende Regionen der Wärmeleitelemente gerichtet werden, was die Wärmeübertragung verbessert.

Weitere Einzelheiten und vorteilhafte Weiterbildungen der Erfindung ergeben sich aus den im folgenden beschriebenen und in der Zeichnung dargestellten, nicht als Einschränkung der Erfindung zu verstehenden Ausführungsbeispielen. Es zeigt:

Fig. 1     einen Schnitt durch einen Wärmeaufnehmer, gesehen längs der Linie 1-1 der Fig. 4,

Fig. 2     eine Draufsicht, gesehen in Richtung der Linie 11-11 der Fig. 1,

Fig. 3     eine raumbildliche Darstellung analog Fig. 1, wobei die Schnittebene mit Fig. 1 übereinstimmt,

Fig. 4     eine Draufsicht, gesehen in Richtung des Pfeiles IV der Fig. 1,

Fig. 5     eine Darstellung des Wärmeaufnehmers im geschlossenen Zustand,

Fig. 6     eine Darstellung analog Fig. 5, bei der aber die vier Anpressfedern und die zugehörigen Schrauben schematisch dargestellt sind,

Fig. 7     eine Darstellung analog Fig. 1, in der schematisch der Verlauf des Kühlfluidstroms eingetragen ist,

Fig. 8     eine Darstellung analog Fig. 1, 3 und 7, in der schematisch ein Substrat sowie der von ihm ausgehende Wärmestrom eingetragen sind, z. B. der sog. "die" eines Mikroprozessors,

Fig. 9     eine raumbildliche Darstellung, gesehen von der Unterseite des Wärmeaufnehmers, wobei die Kühlplatte 68 entfernt ist,

Fig. 10    eine stark vergrößerte Darstellung einer Düsenplatte mit neun runden Düsenöffnungen 58,

Fig. 11    eine Darstellung analog Fig. 10, bei der im Unterschied zu Fig. 10 fünf schlitzartige Düsenöffnungen verwendet werden,

Fig. 12    eine raumbildliche Darstellung einer Variante zu Fig. 9, bei der ebenfalls die Kühlplatte 68 entfernt ist,

Fig. 13    eine Darstellung analog Fig. 6, aber gesehen im Längsschnitt durch die beiden vorderen Dome 24 und 30,

Fig. 14    einen Schnitt durch eine Variante, wobei die Schnittebene analog zu Fig. 1 verläuft,

Fig. 15    eine vergrößerte Schnittdarstellung des zentralen Teils eines Wärmeaufnehmers, analog der Darstellung nach Fig. 14, wobei die Düsenplatte 59" und die Kühlkörper 84" wegen ihrer kleinen Abmessungen nicht maßstabsgerecht dargestellt sind,

Fig. 16    eine stark vergrößerte Darstellung eines erfindungsgemäße Wärmeaufnehmers, gesehen in Richtung des Pfeiles XVI der Fig. 17, wobei die Größenrelationen zwischen den Abmessungen der dargestellten Teile denen einer Ausführungsform entsprechen, welche durch Vergleichsversuche optimiert wurde,

Fig. 17    einen Schnitt, gesehen längs der Linie XVII-XVII der Fig. 16,

Fig. 18    eine vergrößerte Darstellung der Einzelheit XVIII der Fig. 17,

Fig. 19    eine raumbildliche Darstellung des Wärmeaufnehmers der Fig. 16 bis 18, gesehen von der Seite des Kühlkörpers und seiner Halteplatte 114, und

Fig. 20    eine Draufsicht auf den Wärmeaufnehmer, etwa analog Fig. 19.

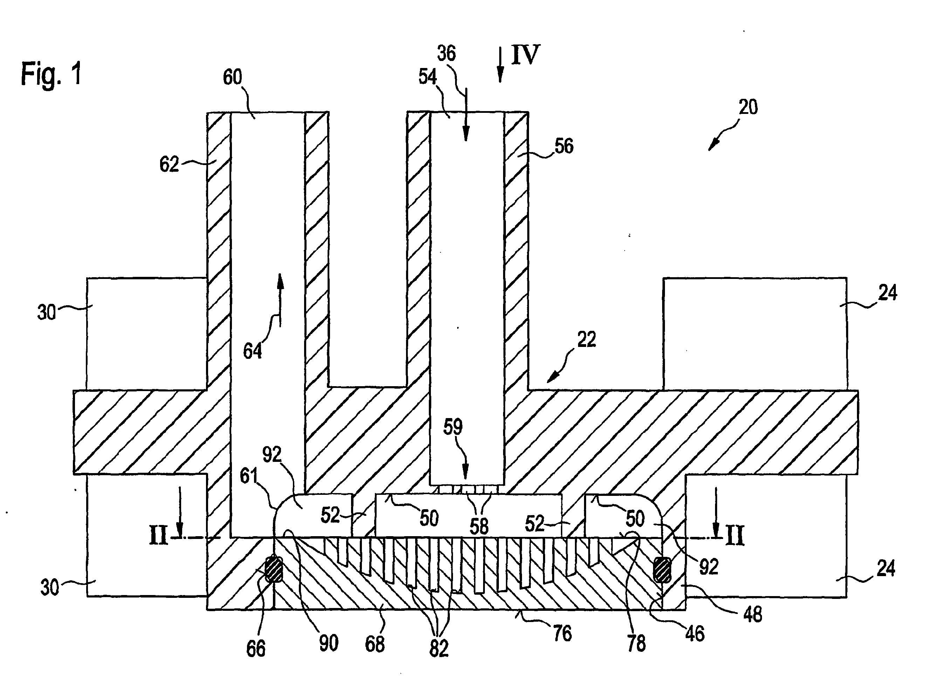

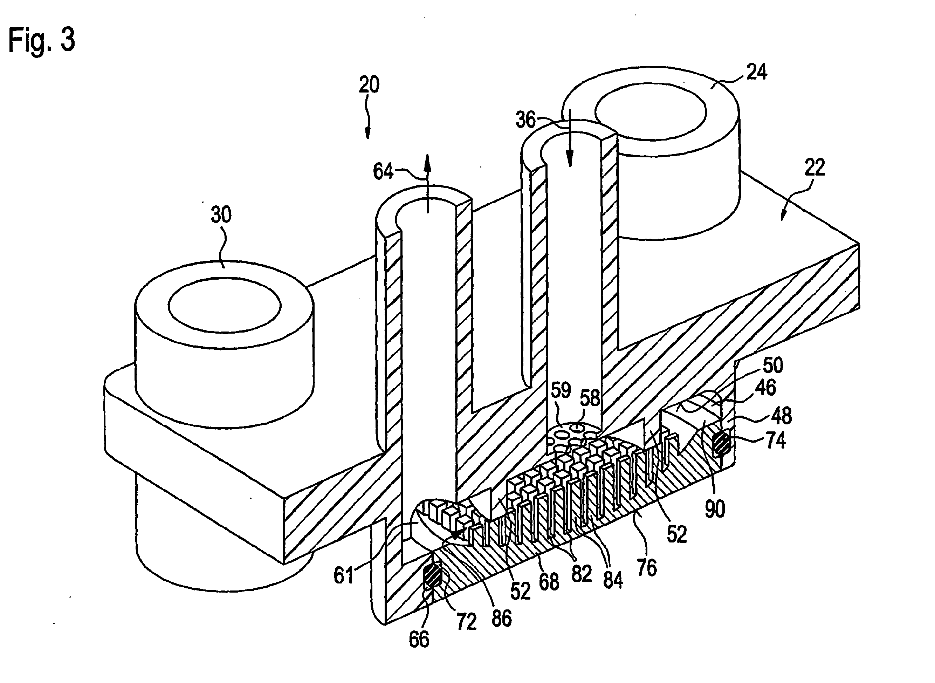

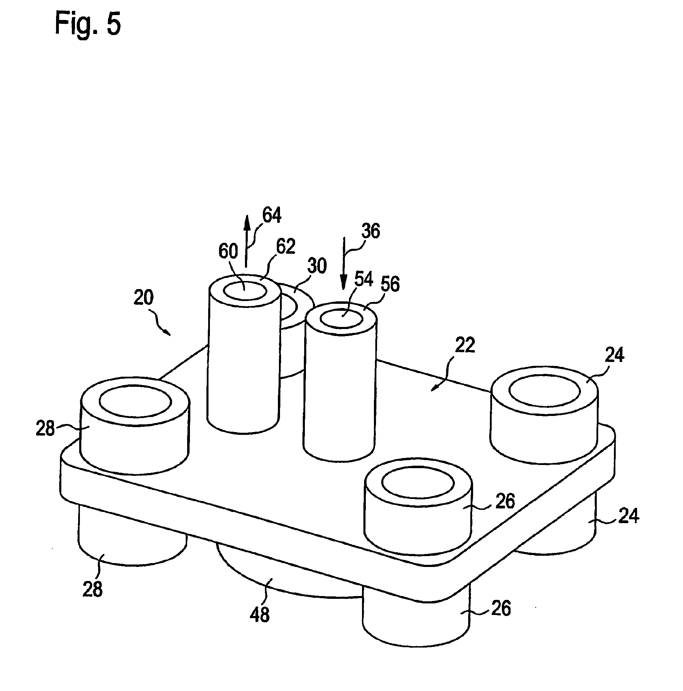

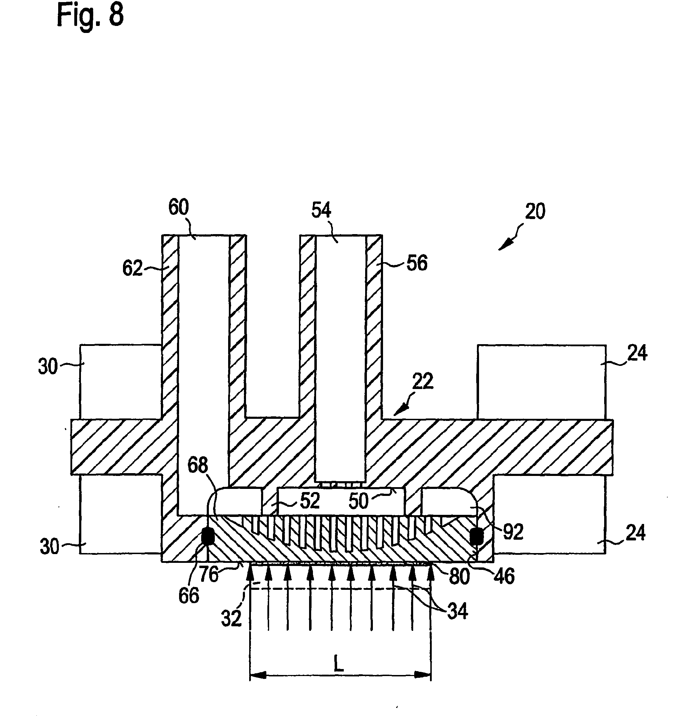

Wie z.B. in Fig.1 und Fig.3 dargestellt ist, hat ein Wärmeaufnehmer 20 bei dem es sich um ein Beispiel handelt, welches das Verständinis, der Erfingung erleichtert, ein Oberteil 22, das als Formstück aus einem geeigneten Werkstoff hergestellt ist, bevorzugt als Spritzgussteil aus einem Kunststoff oder einem geeigneten Metall. Das Oberteil 22 hat hier vier rohrartige Vorsprünge ("Dome") 24, 26, 28, 30, deren Form an besten aus den Fig. 3 bis 6 und 13 hervorgeht und die dazu dienen, das Oberteil 22 in Richtung zu einem zu kühlenden Substrat 32 zu pressen, das in Fig. 8 mit gestrichelten Linien angedeutet ist. Das Substrat 32 kann z. B. der sog. "die" eines Mikrocomputers (CPU) sein, der meist eine quadratische oder rechteckige Form hat, in der er auf einer kleinen Fläche eine hohe Wärmeleistung erzeugt, was einen entsprechenden Wärmestrom zur Folge hat, der in Fig. 8 durch Pfeile 34 symbolisch angedeutet ist.

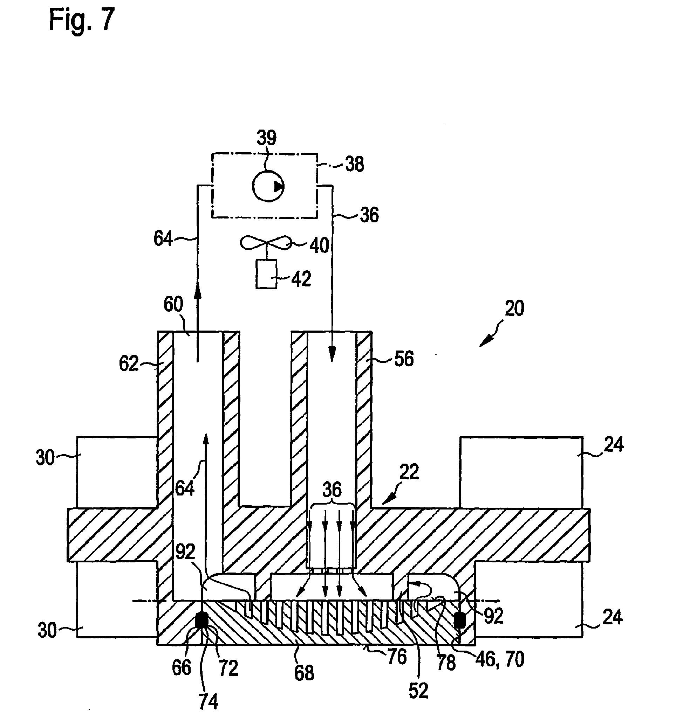

Dieser Wärmestrom 34 muss vom Wärmeaufnehmer 20 aufgenommen und über ein Kühlfluid 36 (Fig. 1 und 7) zu einer Kühleinrichtung 38 beliebiger Bauart abgeleitet und dort z. B. durch einen Ventilator 40, der mit einem Motor 42 versehen ist, an die Umgebungsluft abgegeben werden. Die Kühleinrichtung 38 kann mit Vorteil eine Umlaufpumpe 39 für die Kühlflüssigkeit 36 enthalten.

Die Kühleinrichtung 38, die Art des Kühlfluids 36, sowie die weitere Art der Wärmeabfuhr, sei es über Luft, sei es über eine andere Flüssigkeit, sind nicht Teil der vorliegenden Erfindung und werden deshalb hier nur soweit angedeutet, wie das für das Verständnis der Erfindung und ihres Umfelds zweckmäßig erscheint.

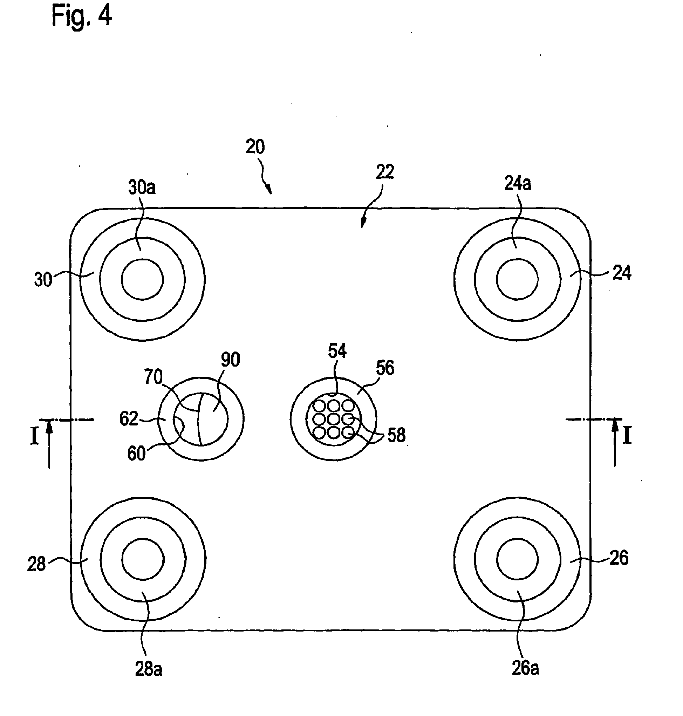

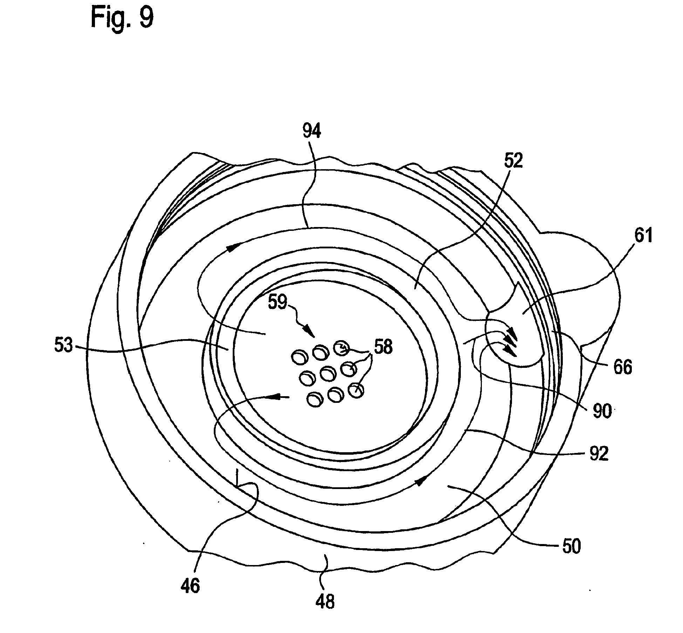

Das Oberteil 22 hat nach unten hin eine zylindrische Ausnehmung 46 (Fig. 9) in einem nach unten ragenden Fortsatz 48. Die Ausnehmung 46 ist nach unten hin offen und nach oben durch die Unterseite 50 des Oberteils 22 begrenzt. An dieser Unterseite 50 befindet sich ein nach unten ragender rohrartiger Vorsprung 52, der in der Draufsicht von unten die Form eines Ringes oder Rohres haben kann, vgl. Fig. 9, und etwa konzentrisch zum Düsenfeld 59 am Auslass 54 eines Zuführstutzens 56 für das Kühlfluid 36 angeordnet ist. Im Bereich der Auslassöffnung 54 ist das Düsenfeld 59 angeordnet, z. B. in Form von neun Löchern 58, wie in Fig. 4, 9 und 10 dargestellt.

Wie **Fig. 9** zeigt, kann der Vorsprung 52 auf seiner Innenseite und an seiner von einer Auslassöffnung 61 abgewandten Seite mit Vorteil eine Anfasung 53 haben, die in Richtung zu dieser Auslassöffnung 61 in der dargestellten Weise bevorzugt kontinuierlich abnimmt und sich bei diesem Beispiel über etwa 3/4 des Umfangs des Vorsprungs 52 erstreckt. Man erreicht so, dass der Strömungswiderstand, welcher durch den Vorsprung 52 gebildet wird, nicht in allen Richtungen gleich ist, sondern in Richtung zur Öffnung 61 zunimmt.

An ihrem in Fig. 1 linken Rand geht die Ausnehmung 46 über diese Auslassöffnung 61 über in den Auslasskanal 60 eines Auslassstutzens 62. Das erwärmte Kühlfluid 64 strömt durch den Stutzen 62 zurück zum Kühlaggregat 38, vgl. Fig. 7.

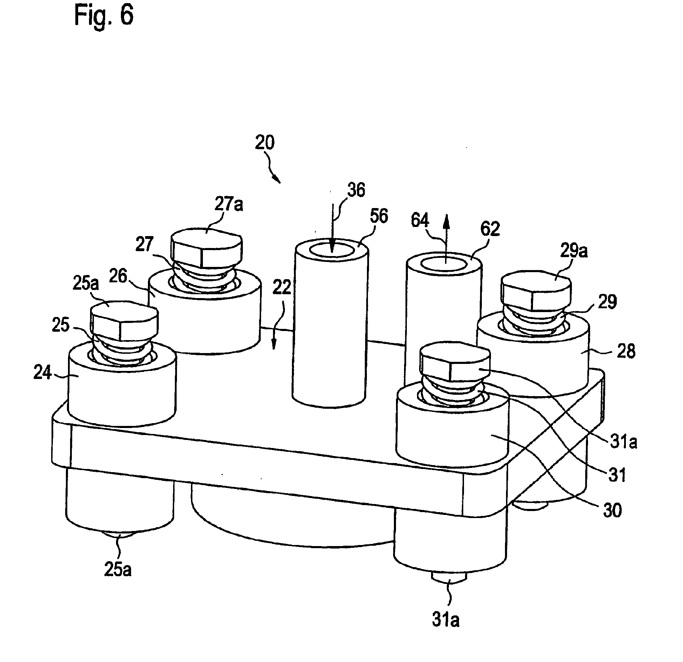

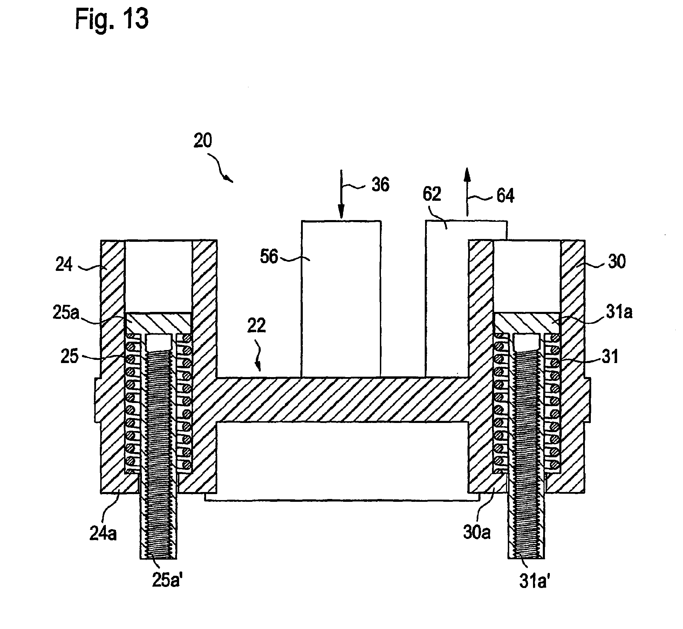

Fig. 6 zeigt schematisch die Art der Befestigung eines Wärmeaufnehmers 20. Diese hat vier Dome 24, 26, 28, 30, und in diesen wird jeweils eine Druckfeder 25, 27, 29 bzw. 31 so eingelegt, dass sie auf einem nach innen ragenden Flansch 24a, 26a, 28a bzw. 30a des betreffenden Domes aufliegt, vgl. Fig. 13.

Gemäß Fig. 6 und Fig. 13 wird in jede Feder eine Schraube 25a, 27a, 29a bzw. 31 a gesteckt, und diese Schrauben werden in ein nicht dargestelltes Gegenglied geschraubt, wodurch die Federn 25 bis 31 mit einer vorgegebenen Kraft gespannt werden. Mit dieser Kraft wird der Wärmeaufnehmer 20 gegen das DIE 32 (Fig. 8) gepresst, um einen guten Wärmeübergang und dadurch eine gute Kühlung des DIE 32 zu erhalten.

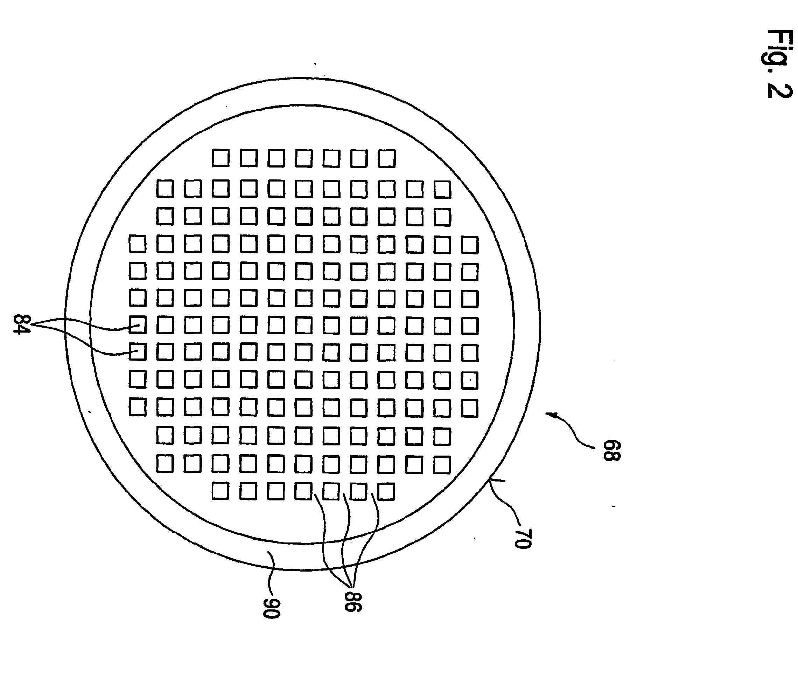

Die zylindrische Öffnung 46 hat eine Ringnut 66 oder zumindest eine Ringschulter. Ein Wärmeaufnehmerteil 68 (Fig. 2) hat einen zylindrischen Umfang 70, und in diesem befindet sich eine zur Ringnut 66 komplementäre Ringnut 72. Zwischen den Ringnuten 66, 72 befindet sich, wie dargestellt, ein Dichtring 74, welcher das Wärmeaufnehmerteil 68 gegen das Oberteil 22 abdichtet. Für diese Abdichtung können beliebige Dichtmittel verwendet werden, wie das für den Fachmann selbstverständlich ist. Ggf. ist auch eine permanente Verbindung zwischen dem Oberteil 22 und dem Wärmeaufnehmerteil 68 möglich, z.B. durch Kleben oder Schweißen.

Das Teil 68 ist aus einem gut Wärme leitenden Werkstoff hergestellt, z. B. aus Kupfer, Aluminium oder Silber. Die Art des verwendeten Werkstoffs hängt u. a. von der Anwendung und den Anforderungen an Lebensdauer und Betriebssicherheit ab. Wie aus den verschiedenen Figuren hervorgeht, hat das Teil 68 bei diesem Beispiel generell die Form einer runden Platte mit einer ebenen Unterseite 76 und einer dazu parallelen Oberseite 78, in welche eine Vertiefung eingearbeitet ist, deren generelle räumliche Umrissform der Form einer Mulde entspricht. Die Unterseite 76 ist fein bearbeitet, um einen optimalen Wärmekontakt mit dem Substrat 32 zu erhalten, wobei zwischen der Unterseite 76 und dem Substrat 32 gewöhnlich eine Wärmeleitpaste 80 angeordnet ist, um den Wärmeübergang zu optimieren. Versuche haben gezeigt, dass die Dicke des Bodens des Teils 68 bei hohen Wärmestromdichten so niedrig sein sollte, soweit das mit der mechanischen Stabilität vereinbar ist.

Die muldenartige Vertiefung 82 ist so angeordnet, dass ihre Mitte im Gebrauch im Wesentlichen über der Mitte des Substrats 32 liegt. Die Vertiefung 82 hat hier etwa die Form einer Kugelkalotte, doch sind auch andere Formen dieser konkaven Struktur möglich, z. B. ein Rotationsparaboloid, oder die Form einer flachen Schale mit einem im Wesentlichen flachen Boden.

Wie die Fig. 2 und 3 am besten zeigen, ragen vom Boden der muldenförmigen Vertiefung 82 säulenartige Kühlkörper oder Wärmeleitelemente 84 nach oben bis zur Oberseite 78 des Wärmeaufnehmerteils 68. Diese Kühlkörper 84 können wegen ihres nadelartigen Aussehens auch als Pins bezeichnet werden. Zwischen ihnen befinden sich Kanäle 86, d. h. der Kühlkörper 84 wird bevorzugt dadurch hergestellt, dass entsprechende Kanäle 86 kreuz und quer in die Oberseite 78 des Teils 68 eingearbeitet werden, wie das für den Fachmann aus den Darstellungen ohne weiteres ersichtlich ist. Bevorzugt werden die Kühlkörper 84 nach ihrer Herstellung durch Sandstrahlen aufgeraut, um den Wärmeübergang an ihrer Oberfläche weiter zu verbessern.

Selbstverständlich gibt es verschiedenen Arten, solche säulenartigen Kühlkörper 84 herzustellen, z. B. auch mittels geeigneter Erosionswerkzeuge, welche es ermöglichen, einen unregelmäßigen Verlauf der Kanäle 86 zu erzielen und dadurch die Strömungsverhältnisse gezielt so zu beeinflussen, dass die Wärmeabfuhr weitgehend symmetrisch und damit optimiert erfolgt.

Die muldenförmige Vertiefung 82 stellt, wie bereits beschrieben, einen Hüllkörper dar, der durch die Nadeln 84 unterbrochen ist. Die Vertiefung 82 endet bei dieser Ausführungsform vor dem zylindrischen Umfang 70 der Kälteplatte 68, so dass dort ein flacher Randabschnitt 90 entsteht. Zusammen mit der Unterseite 50 des Oberteils 22, der zylindrischen Ausnehmung 46 und dem Vorsprung 52 bildet er einen Ringkanal 92, der sich in Fig. 1 links mit dem Auslasskanal 60 schneidet, da die Mittelachse des Auslasskanals 60 etwa mit dem äußeren Rand des Kanals 92 zusammen fällt, so dass das erwärmte Kühlfluid 64, das in etwa radialer Richtung aus den Kanälen 86 des Teils 68 ausströmt, in diesem Ringkanal 92 gesammelt wird und durch ihn und die Auslassöffnung 61 zum Auslasskanal 60 strömt.

Hierdurch wird erwärmtes Kühlfluid 64 um den zentralen Abschnitt der Kälteplatte 68 herum geleitet und kann sich folglich nicht mit dem kalten Kühlfluid 36 vermischen, das über den Zuführstutzen 56 dem zentralen Abschnitt (innerhalb des Rings 52) zugeführt wird. Folglich hat man innerhalb des Rings 52 eine Zone mit sehr kaltem Kühlfluid 36, was dazu dient, dass Substrat 32 (Fig. 8) dort am stärksten zu kühlen, wo dessen größte Wärmeentwicklung ist. Außerhalb des Rings 52 findet im Ringkanal 92 eine Durchmischung des erwärmten Kühlfluids 64 statt, und dort ist folglich die Wärmeabfuhr weniger stark.

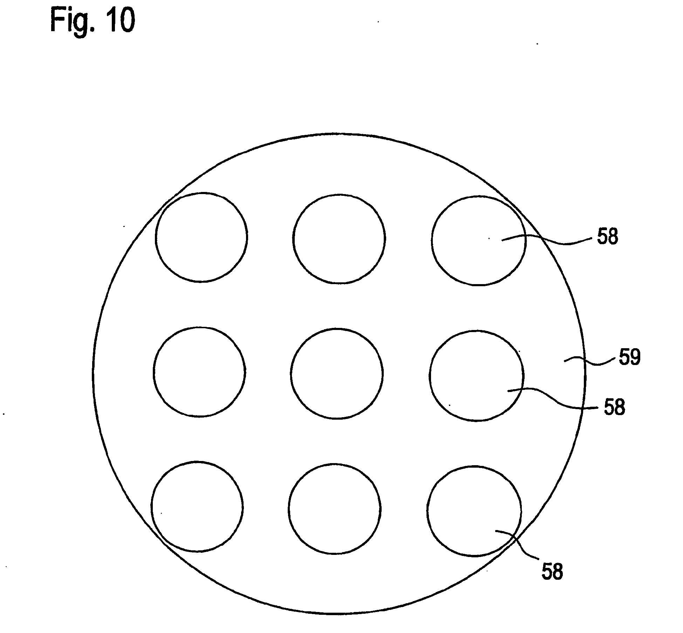

Die Fig. 1, 3, 9 und 14 bis 16 zeigen, dass an der Unterseite des Einlasskanals 54 eine Platte 59 mit den bereits beschriebenen Düsenöffnungen 58 vorgesehen ist. Diese Platte 59 ist stark vergrößert auch in **Fig. 10** dargestellt und bildet ein Düsenfeld.

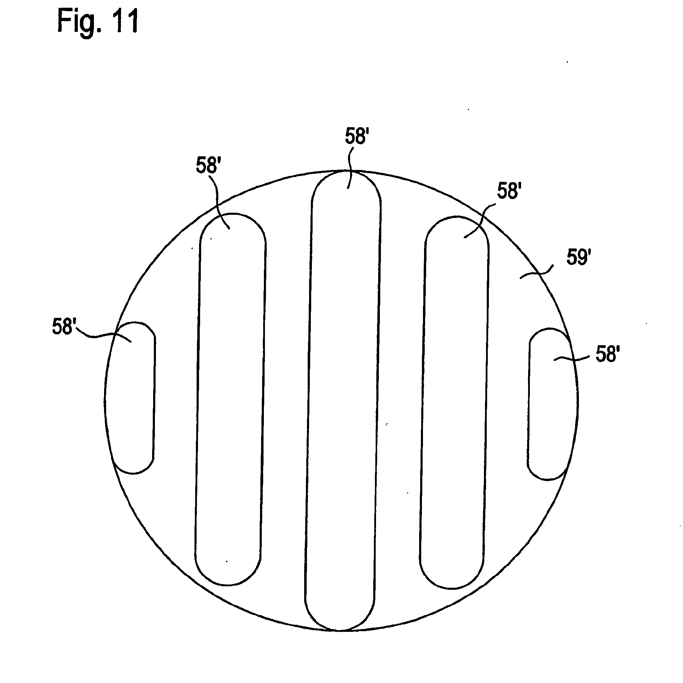

Naturgemäß können Düsen verschiedener Art verwendet werden. Z. B. zeigt **Fig. 11** ein Düsenfeld 59', in das parallele Schlitzdüsen 58' eingearbeitet sind.

Die Düsen 58, 58' bewirken im Betrieb bei bestimmten Strömungsbedingungen, die empirisch leicht zu ermitteln sind, eine Einschnürung des einströmenden Kühlfluids 36. Dadurch fließt dieses schneller und bewirkt beim Auftreffen auf die Kühlkörper (Pins) 84 eine starke Turbulenz und folglich einen besseren Wärmeübergang.

**Arbeitsweise**

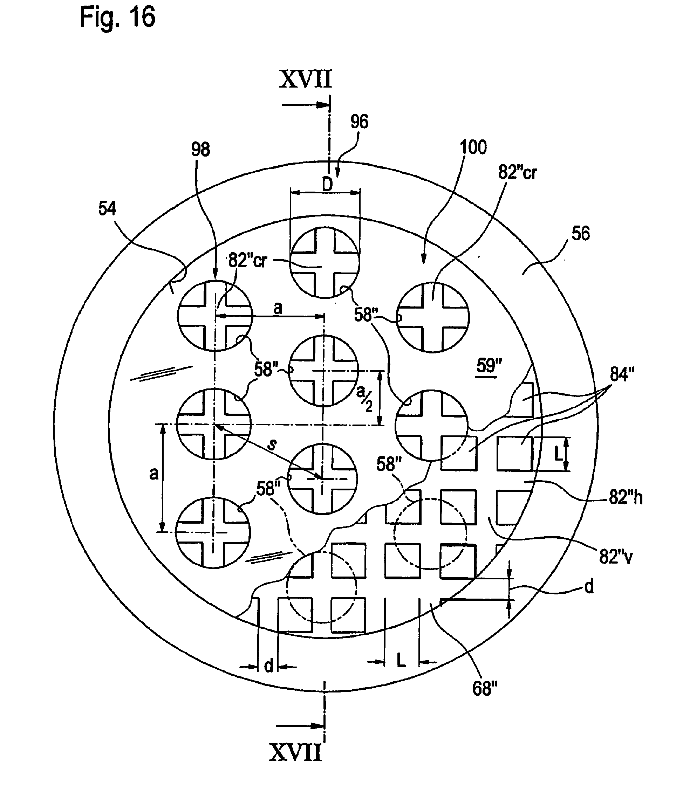

Vom Kühlaggregat 38 wird im Betrieb dem Zufuhrstutzen 56 gekühltes Kühlfluid 36 zugeführt und durch das Düsenfeld 59 (Fig. 3, 4, 7, 9, 10, 14 bis 16) innerhalb des Rings 52 mit hoher Geschwindigkeit auf das Wärmeaufnehmerteil 68 gespritzt, wobei es sich bevorzugt, wie in Fig. 7 angedeutet, durch den sog. Coanda-Effekt auffächert und dadurch eine gleichmäßige, turbulente Kühlung dieses zentralen Bereichs (innerhalb des Rings 52) bewirkt. Der Coanda-Effekt tritt bei den Düsen auf, die am Rande des Düsenfelds liegen, z.B. in Fig. 16 bei der obersten und der untersten Düse 58".

Das Kühlfluid durchströmt hierbei die Kanäle 86 (Fig. 2) etwa in radialer Richtung nach außen, da die ringförmige Blende 52 auf den Kühlkörpern 84 aufliegt und daher das Kühlfluid 36 zwingt, durch die Kanäle 86 zu fließen (und nicht über diese hinweg), wobei es auch den radial äußeren Bereich 90 des Wärmeaufnehmerteils 68 kühlt.

Aus den Kanälen 86 gelangt das erwärmte Kühlfluid 64 in den Ringkanal 92, und durch diesen über die Auslassöffnung 61 zum Abflussstutzen 60 und zurück zur Kühleinrichtung 38, wo es seine Wärme abgibt, z. B. an die Umgebungsluft, wie durch den Ventilator 40 angedeutet.

Es ist darauf hinzuweisen, dass als Kühlfluid z. B. auch eine siedende Kühlflüssigkeit verwendet werden kann, die bei einer Temperatur verdampft, die unterhalb der maximalen Temperatur des zu kühlenden Substrats 32 liegt.

Durch die muldenförmige Vertiefung 82 erreicht man den zusätzlichen Vorteil, dass der Wärmeaufnehmer 20 unempfindlich gegen leichte Schräglagen ist, wie sie in der Praxis z. B. bei einem Computer immer wieder vorkommen, weil ja, wie in Fig. 8 durch die Pfeile 34 angedeutet, im Wärmeaufnehmers 20 eine gewisse Zwangskonvektion stattfindet, die von dessen Lage wenig abhängig ist.

Man erhält also einen von einem Kühlfluid durchströmten Wärmeaufnehmer 20, der ein hohes Oberflächenangebot aufweist und in dem kaltes Kühlfluid zunächst auf Regionen mit hohen absoluten Temperaturen trifft. Dabei wird verhindert, dass bereits erwärmtes Kühlfluid 64 sich mit frischem, kaltem Fluid 36 durchmischt, bevor letzteres auf die Regionen mit den höchsten absoluten Temperaturen trifft. Dies bedeutet umgekehrt, dass bereits erwärmtes Fluid möglichst schnell aus Zonen mit den höchsten absoluten Temperaturen abgezogen wird. Zusätzlich werden die Regionen mit den höchsten absoluten Temperaturen auch mit möglichst hohen Strömungsgeschwindigkeiten des Kühlfluids 36 angeströmt.

Wie der Fachmann den Fig. 1 und 4 entnimmt, würde ohne den Ring 52 das zugeführte Kühlfluid 36 auf dem direkten Weg vom Einlassstutzen 56 zum Auslassstutzen 62 strömen und dabei nur den linken Teil des Wärmeaufnehmerteils 68 intensiv kühlen, so dass auch das Substrat 34 (Fig. 8) auf seiner linken Seite stärker gekühlt würde als auf seiner rechten.

Der als Blende wirksame Ring 52 wirkt dem entgegen und zwingt das Kühlfluid 36, in alle Richtungen zu strömen und dadurch die Kälteplatte 68 gleichmäßiger zu kühlen. Wenn aber der Ring 52 überall dieselben Dimensionen hat, wie das in Fig. 1 dargestellt ist, kann trotzdem eine asymmetrische Kühlung entstehen, weil das Kühlfluid 36 stets den Weg des geringsten Widerstandes nimmt, also in Fig. 1 vom Zufluss 56 hauptsächlich direkt nach links zum Auslass 62.

Aus diesem Grund ist in Fig. 9 der Ring 52 mit der Anfasung 53 versehen, die dort am stärksten ist, wo sie der Auslassöffnung 61 gegenüber liegt. Diese Anfasung 53 könnte auch auf der Außenseite des Rings 52 angeordnet werden. Durch die Anfasung ergibt sich für Kühlfluid 36, das über die Düsen 54 zuströmt, ein relativ hoher Strömungswiderstand für eine direkte Strömung zum Auslass 62, die in Fig. 9 mit 90 bezeichnet ist, während der Strömungswiderstand für Strömungen 92, 94, die über die Stellen mit einer großen Anfasung 53 gehen, geringer ist. Dadurch wird erreicht, dass die Kühlung des Teils 68 (Fig. 2) insgesamt gleichmäßiger wird, d. h. dass hohe Temperaturgradienten in der Kälteplatte 68 vermieden werden.

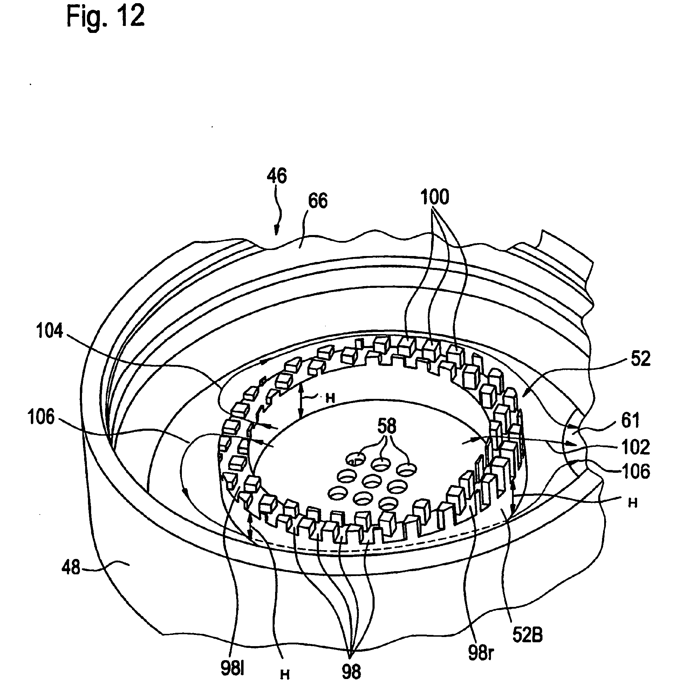

**Fig. 12** zeigt hierzu eine Variante. Hier ist die Basis 52B des Rings 52 massiv ausgebildet und hat überall dieselbe Höhe H. Von dieser Basis 52B ragen in Fig. 12 unterschiedlich lange Vorsprünge 100 in der dargestellten Weise nach oben. Sie sind durch Kanäle 98 voneinander getrennt. Diese Kanäle sind in Fig. 12 links mit 98l bezeichnet, und rechts, in der Nähe der Auslassöffnung 61, mit 98r. Man erkennt also, dass die Vorsprünge 100 in Fig. 12 auf der linken Seite niedrig sind, und dass sie auf der rechten Seite hoch sind.

Die Vorsprünge 100 sind so ausgebildet, dass sie in Fig. 2 in die Zwischenräume 86 zwischen den Kühlkörpern 84 ragen und dort, abhängig von ihrer Länge, wie unterschiedlich starke Drosseln wirken. Dadurch wird in Fig. 12 der direkte Kühlfluidstrom 102 vom Düsenfeld 58 zum Auslass 61 stark gedrosselt, während die Kühlfluidströme 104, 106 von der in Fig. 12 linken Seite zum Auslass 61 nur wenig oder gar nicht gedrosselt werden, so dass insgesamt die Kälteplatte 68 in symmetrischer Weise und nicht einseitig gekühlt wird.

Wie bei Fig. 6 beschrieben, hat das Gehäuse 22 Befestigungsmöglichkeiten, mit denen der Wärmeaufnehmer 20 an bereits vorhandene Befestigungspunkte montiert werden kann, welche sich in dem System befinden, zu dem das zu kühlende Bauteil 32 gehört. Alternativ ist eine Befestigung am Sockel des Substrats 32, an der zugehörigen Hauptplatine, oder an einem sonstigen Bauteil in sog. Clip-Technik möglich.

Insgesamt ist ein solcher Wärmeaufnehmer 20 sehr preiswert herstellbar, weil das Oberteil 22 mit seiner komplizierten Form preiswert als Spritzgussteil hergestellt und für die Anforderungen eines bestimmten Prozessortyps optimiert werden kann. Die Pins 84 der Kälteplatte 68 und ihre Zwischenräume 86 haben bevorzugt Abmessungen, die mit wirtschaftlichen Fertigungsverfahren herstellbar sind, z. B. eine Breite der Pins 84 in einer Größenordnung unter 2 mm. Dasselbe gilt analog für die Anordnung nach Fig. 12. Nachfolgend werden bei Fig. 16 Maße beschrieben, die nach heutiger Kenntnis als optimal angesehen werden können.

Die eingefügte Kälteplatte 68 hat einen Absatz oder eine Ringnut 72, die einen Teil der Dichtkanten zur fluiddichten Abdichtung zwischen Oberteil 22 und Kälteplatte 68 bereitstellt. Mindestens eine andere Dichtkante (Ringnut 66) wird vom Oberteil 22 bereitgestellt. Das Oberteil 22 hat mindestens einen Einlassstutzen 56 und mindestens einen Auslassstutzen 62. Der Einlassstutzen 56 befindet sich im Zentrum, und der Auslassstutzen 62 schneidet mit seiner Mittelachse etwa den äußeren Rand des Ringkanals 92. Die sich hierdurch ergebende Durchdringung der Körper ergibt einen rechteckigen Auslass 61 aus dem Ringkanal 92, und dieser Auslass hat einen großen Querschnitt und folglich einen geringen Strömungswiderstand. Die Eckkanten der Durchdringung können zwecks weiterer Verringerung der Strömungswiderstände abgerundet werden.

Der Einlassstutzen 56 hat bevorzugt an seinem inneren Ende eine Blende 59, an welcher Runddüsen 58 oder Schlitzdüsen 58' vorgesehen sein können, so dass ein Düsenfeld entsteht. Beim Durchströmen dieses Düsenfelds 59 bzw. 59' wird das Kühlfluid 36 beschleunigt, und der Fluidstrahl schnürt sich nach dem Austreten aus dem Düsenfeld sogar noch ein (Coanda-Effekt), was zu einer weiter erhöhten Strömungsgeschwindigkeit führt. Somit trifft das kalte Kühlfluid 36 mit hoher Geschwindigkeit auf Regionen mit hohen absoluten Temperaturen. Zusätzlich sind die Oberflächen in einem ausgewogenen Verhältnis durch die Pins 84 vergrößert. Anstelle der Pins 84 könnten auch entsprechende Rippen verwendet werden, was nicht dargestellt ist.

Der Ring 52 zwingt das Kühlfluid 36 dazu, am Fuße der Pins 84 durchzuströmen, und anschließend werden dem Fluid im äußeren Ringraum 92 nur noch geringe Strömungswiderstände auferlegt, so dass eine Rückströmung und Durchmischung mit kaltem Kühlfluid 36 zusätzlich erschwert wird. Zu diesem Zweck kann das Oberteil 22 auch einen Auslassquerschnitt besitzen, welcher größer ist als der Einlassquerschnitt.

**Fig. 13** zeigt eine Darstellung analog Fig. 6, aber im Schnitt. Die Bezugszeichen sind dieselben wie in Fig. 6. Man erkennt, dass die Teile 25a, 31a Innengewinde 25a' bzw. 31a' haben, und dass die Federn 25 und 31 gespannt werden, wenn die Teile 25a, 31a nach unten gezogen werden, z.B. durch - nicht dargestellte - Schrauben, die zur Befestigung an einer Leiterplatte dienen.

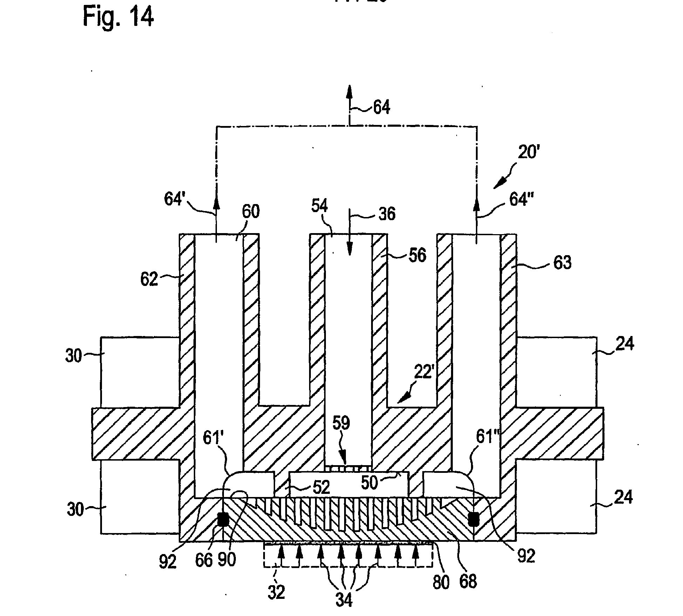

**Fig. 14** zeigt eine Variante, die sehr ähnlich aufgebaut ist wie Fig. 1, aber im Gegensatz zu Fig. 1 zwei Abflussstutzen 62, 63 hat.

Die linke Hälfte von Fig. 14 stimmt mit der linken Hälfte von Fig. 1 überein, ebenso die Kälteplatte 68, weshalb für diese Teile dieselben Bezugszeichen verwendet werden. Dort befindet sich ein Abflussstutzen 62 wie in Fig. 1.

Ferner befindet sich auf der rechten Hälfte der Fig. 14 ein zweiter Abflussstutzen 63, der dem ersten Abflussstutzen 62 symmetrisch gegenüber liegt. Das Kühlfluid 36 fließt also durch den Zuflussstutzen 56 zentral zu, strömt durch das Düsenfeld 59 auf die Prallplatte 68, wo es Wärme von dieser aufnimmt, und teilt sich dann auf, d.h. die eine Hälfte fließt nach links zum Abflussstutzen 62, und die andere nach rechts zum Abflussstutzen 63. Im Stutzen 62 hat man also die Strömung 64', und im Stutzen 63 die Strömung 64", und diese Fluidströme werden anschließend durch Verbindungen, die nur schematisch angedeutet sind, zu einer Abflussströmung 64 vereinigt.

Der Vorteil bei Fig. 14 ist, dass die Kälteplatte 68 symmetrischer gekühlt wird als bei Fig. 1, denn bei Fig. 1 kann, bedingt durch die Geometrie der Anordnung, die linke Hälfte etwas besser gekühlt werden als die rechte.

In Fig. 14 wird ebenso wie bei Fig. 1 der Ring 52 verwendet, um eine Vermischung von kaltem Fluid 36 mit bereits erwärmtem Fluid 64', 64" zu vermeiden, und dieser Ring kann ebenfalls mit Anfasungen oder Vorsprüngen versehen sein, welche so ausgebildet sind, dass in der Nähe der Auslassstutzen 62, 63 ein etwas erhöhter Strömungswiderstand für das Kühlfluid entsteht.

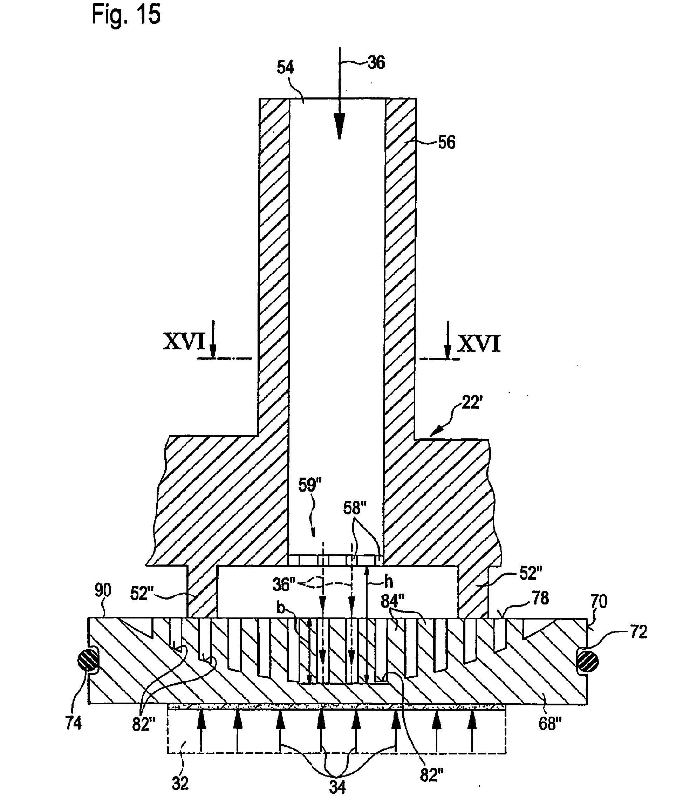

**Fig. 16** zeigt einen Ausschnitt aus einem praktischen Ausführungsbeispiel der Erfindung, das sich bei Vergleichsversuchen besonders bewährt hat. Diese Darstellung entspricht dem Schnitt XVI-XVI der Fig. 15, enthält aber Einzelheiten, die in Fig. 15 zeichnerisch nicht darstellbar sind.

Der in Fig. 16 untere Teil des Düsenfelds 59" ist weggeschnitten dargestellt, um Lage und Größe der dort verwendeten Kühlkörper 84" im Verhältnis zur Lage der Öffnungen 58" des Düsenfelds 59" besser verständlich zu machen. Die Lage der Öffnungen 58" im unteren Teil der Fig. 16 ist durch strichpunktierte Linien angedeutet.

Wie Fig. 15 schematisch zeigt, sind die Öffnungen 58" in Relation zu den säulenartigen Kühlkörpern 84" und den zwischen ihnen ausgearbeiteten Kanälen 82" so angeordnet, dass ein Strahl 36" der Kühlflüssigkeit 36, der im Betrieb aus einer Öffnung 58" austritt, etwa auf die Kreuzung eines in Fig. 16 horizontal verlaufenden Kanals 82"h und eines in Fig. 16 vertikal verlaufenden Kanals 82"v zielt. Deshalb ist in der Darstellung nach Fig. 16 durch eine Düsenöffnung 58" jeweils eine solche Kanalkreuzung 82"cr sichtbar, d.h. ein Strahl 36" zielt auf die tiefste Stelle eines Kanals 82", also auf die Stelle, wo die Temperatur am höchsten ist, die vom elektronischen Bauelement 32 (Fig. 15) erzeugt wird.

Die Anordnung der Düsen 58" ist so gewählt, dass die Wärmeabfuhr von den Kühlkörpern 84" möglichst gleichmäßig erfolgt. In Fig. 16 ist eine mittlere vertikale Reihe 96 von vier gleichmäßig verteilten Düsenöffnungen 58" vorgesehen, und parallel dazu, aber seitlich versetzt, eine linke Reihe 98 und eine rechte Reihe 100 mit jeweils drei Düsen 58". Mit einer solchen Anordnung haben sich bei Versuchen gute Resultate ergeben. In Fig. 15 und 16 sind die Maße a, d, D, h und L eingetragen. Dabei bedeutet d die (gewöhnlich übereinstimmende) lichte Weite der Kanäle 82"h und 82"v. Der Querschnitt der Kühlelemente 84" ist bevorzugt etwa quadratisch, und ein solches Quadrat hat eine Seitenlänge L. Versuche haben ergeben, dass der Querschnitt der Kühlelemente 84, 84', 84" etwa proportional zur Breite d der Kanäle 82" sein sollte, und dass man die besten Ergebnisse erhält, wenn

$$L = (1{,}4 \ldots 2{,}0) * d \qquad \ldots (1)$$

ist, wobei L und d in mm gemessen werden. Z.B. hat sich für eine Größe d = 0,3 mm ein Wert L von 0,4 ... 0,6 mm als besonders günstig erwiesen, also ein Querschnitt von etwa 0,1 bis etwa 0,4 mm$^2$.

Die Kühlkörper 84" haben - wegen der leichten Herstellbarkeit - bevorzugt einen quadratischen Querschnitt. Falls ein anderer Querschnitt gewählt wird, z. B. ein kreiszylindrischer Querschnitt, geht man aus vom mittleren Querschnitt, also vom bewerteten (weighted) Mittelwert der Querschnitte der einzelnen Kühlkörper, der mit Q bezeichnet wird. Dieser liegt gewöhnlich im Bereich 0,1 ... 0,4 mm$^2$. Die Beziehung zwischen diesem Wert und der lichten Weite d der Kanäle 82" zwischen den Kühlkörpern 84" gehorcht bevorzugt folgender Beziehung:

$$d = (0{,}25 \ldots 0{,}5) * \exp (0{,}5 * \ln Q) \qquad \ldots (2)$$

Dabei wird d in mm und Q in mm$^2$ gemessen.

lnQ = natürlicher Logarithmus von Q.

Dies ergibt also nach derzeitiger Kenntnis einen bevorzugten Wertebereich für den Wert d, wenn Q bekannt ist.

Wenn die Größe eines zu kühlenden elektronischen Leistungsbauteils 32 abnimmt, nimmt meistens dessen Wärmestromdichte zu, und es ist dann notwendig, die Größe der Kühlelemente 84" anzupassen, d.h. die Teile 84" werden noch kleiner, und entsprechend wird gemäß Gleichung (1) auch die Breite der Kanäle 82" noch kleiner. Auch der Durchmesser D der Düsen 58" nimmt in diesem Fall entsprechend ab.

Die Runddüsen 58" haben einen bevorzugten Durchmesser D von etwa 1 bis etwa 1,2 mm. Der in Fig. 15 eingetragene Abstand h zwischen der Düsenplatte 59 und dem Boden der Kanäle 82" an deren tiefsten Stelle hat nach derzeitigen Erkenntnissen ein Optimum, wenn gilt

$$h = (2 \ldots 3) * D \qquad \ldots (3),$$

d.h. dieser Abstand h beträgt für optimale Resultate etwa das Zwei- bis Dreifache des Durchmessers D einer Düse 58". Dieser Abstand h ist in jedem Fall größer als D. (Im Normalfall ist der Durchmesser D bei allen Düsen 58" aus Gründen der einfachen Herstellung etwa derselbe. Die Darstellung in Fig. 15 ist eine schematische Darstellung und kann deshalb diese Maßverhältnisse nicht zeigen, worauf hingewiesen wird.)

Der bevorzugte vertikale Mittenabstand a zwischen zwei benachbarten Düsen ergibt sich aus den angegebenen Maßen, also

$$a = n * L + n * d \qquad \ldots(4),$$

wobei n = 2, 3, ... ist.

Für n = 2 (wie dargestellt) ergibt sich

$$a = 2 * 0{,}6 + 2 * 0{,}3 = 1{,}8 \text{ mm} \qquad \ldots(5)$$

Diese Maße ergaben bei Vergleichsversuchen eine sehr gute Wärmeabfuhr aus dem in Fig. 15 schematisch angedeuteten Bauelement 32. Eine solche Bauform eignet sich besonders gut für Bauelemente 32 mit kleinen Abmessungen und hoher Wärmestromdichte, z.B. für Prozessoren.

Zwei benachbarte Düsen 58" der mittleren Reihe 96 bilden jeweils mit einer benachbarten Düse der Reihe 98 oder der Reihe 100 ein gleichschenkliges Dreieck (isoceles triangle), wobei die Länge s der Schenkel beträgt

$$s = 1{,}12 * a \qquad \ldots(6)$$

Eine solche Anordnung hat sich bei Vergleichsversuchen als günstig herausgestellt, um die anfallende Wärmemenge so abzuführen, dass keine lokalen Temperaturspitzen entstehen.

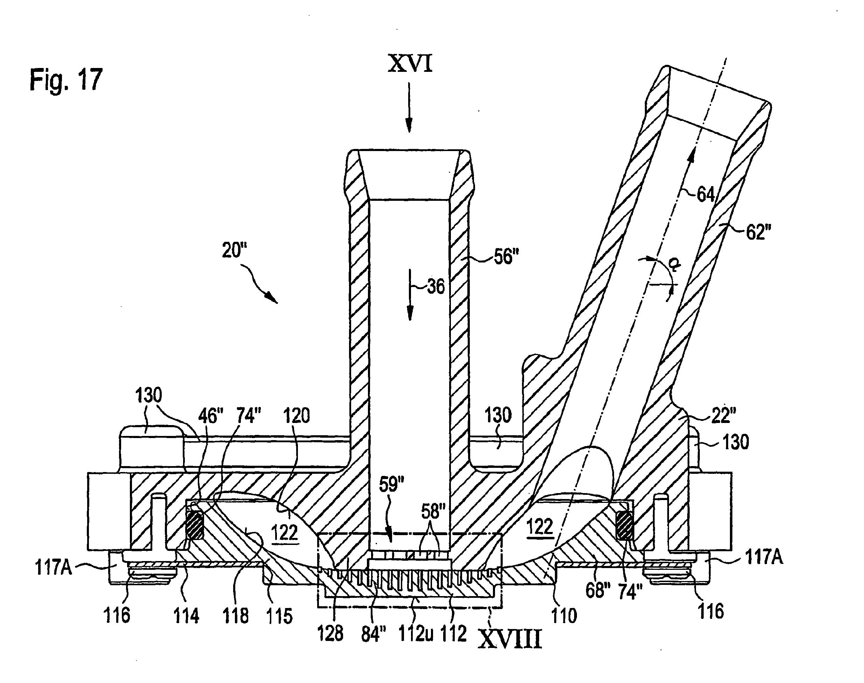

**Fig.17** zeigt den Wärmeaufnehmer 20" der Fig. 16 im zusammengebauten Zustand. Er hat ein Oberteil 22" (Formstück) aus Kunststoff, an dem in der Mitte ein Einlassstutzen 56" und seitlich ein Auslassstutzen 62" vorgesehen sind, welch letzterer unter einem Winkel alpha von bevorzugt etwa 70° schräg nach oben führt.

An dem in Fig. 17 unteren Ende des Einlasses 56" befindet sich die Düsenplatte 59", deren Form am besten aus Fig. 16 hervorgeht. Das Oberteil 22" hat unten eine zylindrische Ausnehmung 46", in welcher das Wärmeaufnehmerteil 68", mittels eines O-Rings 74" abgedichtet, angeordnet ist.

Das Wärmeaufnehmerteil 68" hat bevorzugt etwa die Form einer Scheibe, und hat auf seiner Unterseite einen kreiszylindrischen Vorsprung 110, auf dem sich ein rechteckförmiger Vorsprung 112 befindet, der bei Benutzung mit einer Fläche 112u gegen eine wärmeabgebendes Teil anliegt, z. B. gegen einen IC oder einen $\mu$C, wie das in Fig. 8 für das wärmeabgebende Bauteil 32 dargestellt ist.

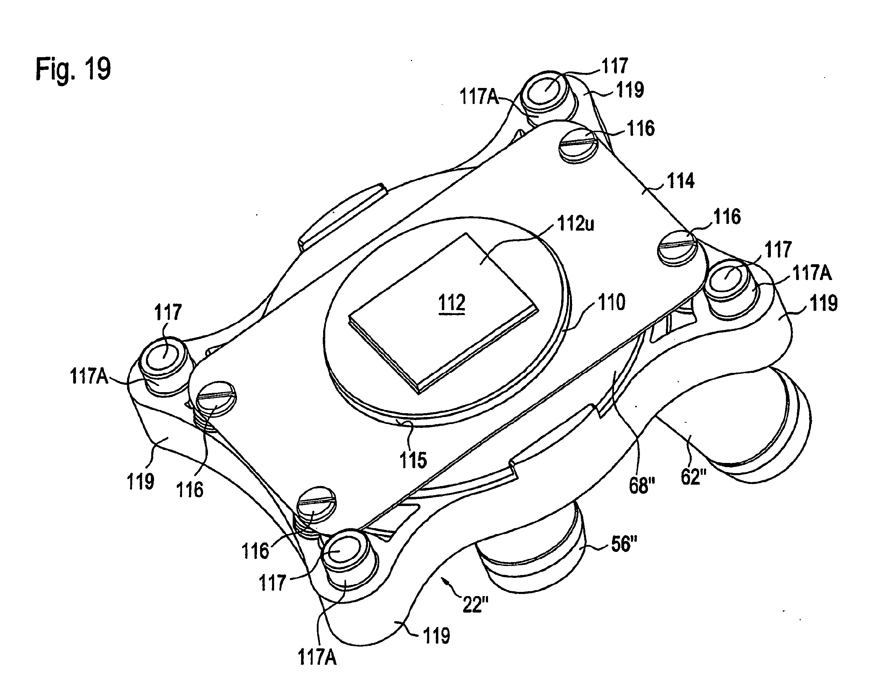

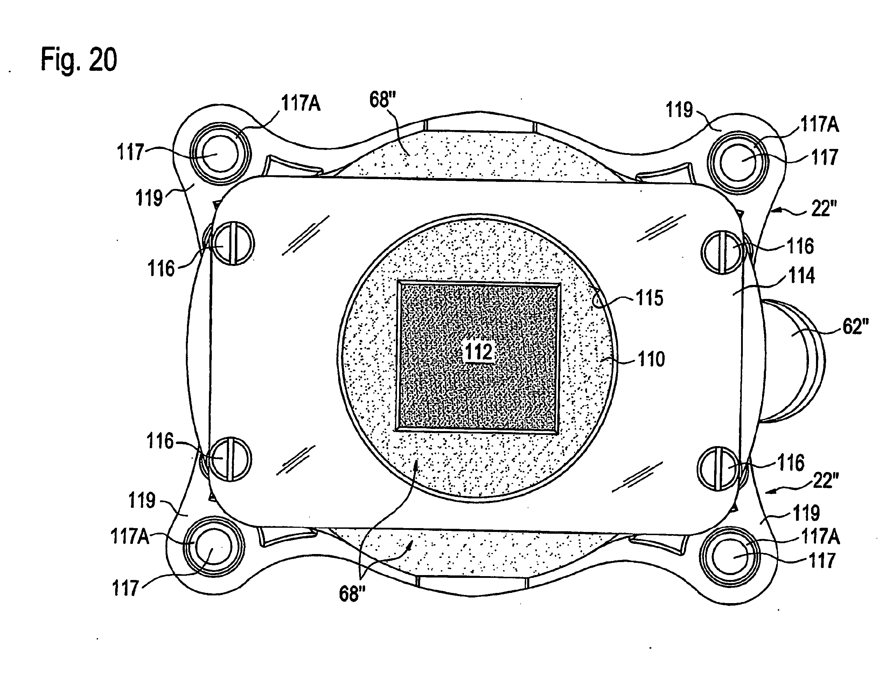

Das Wärmeaufnehmerteil 68" wird durch ein Trageteil, hier in Form einer Halteplatte 114 (Fig. 17, 19 und 20) aus Stahl oder dgl. gehalten. Die Halteplatte 114 hat in ihrer Mitte ein Loch 115, durch welches sich der Vorsprung 110 erstreckt. Zur Verdeutlichung sind in **Fig. 20** diejenigen Teile, welche zum Wärmeaufnehmerteil 68" gehören, grau hervorgehoben. Aus **Fig.19** wird der Aufbau sehr gut erkennbar. Die Halteplatte 114 wird am Oberteil 22" durch vier Schrauben 116 gehalten.

Das Oberteil 22" hat an seinen vier Ecken vier Befestigungslöcher 117, von denen jedes einen hohlzylindrischen Fortsatz 117A hat, der gemäß Fig. 17 über die Schrauben 116 übersteht. Die Löcher 117 befinden sich an radialen Erweiterungen 119 des Gehäuseteils 22", die von diesem pratzenartig nach außen ragen, was die Fig. 19 und 20 am besten zeigen.

Auf diese Weise wird das Wärmeaufnehmerteil 68" von tragenden Funktionen weitgehend entlastet, und kann in seinem zentralen Teil, also im Bereich des rechteckförmigen Vorsprungs 112, sehr dünn ausgebildet werden, z. B., wie dargestellt, im mittleren Bereich mit einer Dicke kleiner als 1 mm, was für eine gute Kühlung von großem Vorteil ist, da man hierdurch einen exzellenten Wärmeübergang erhält.

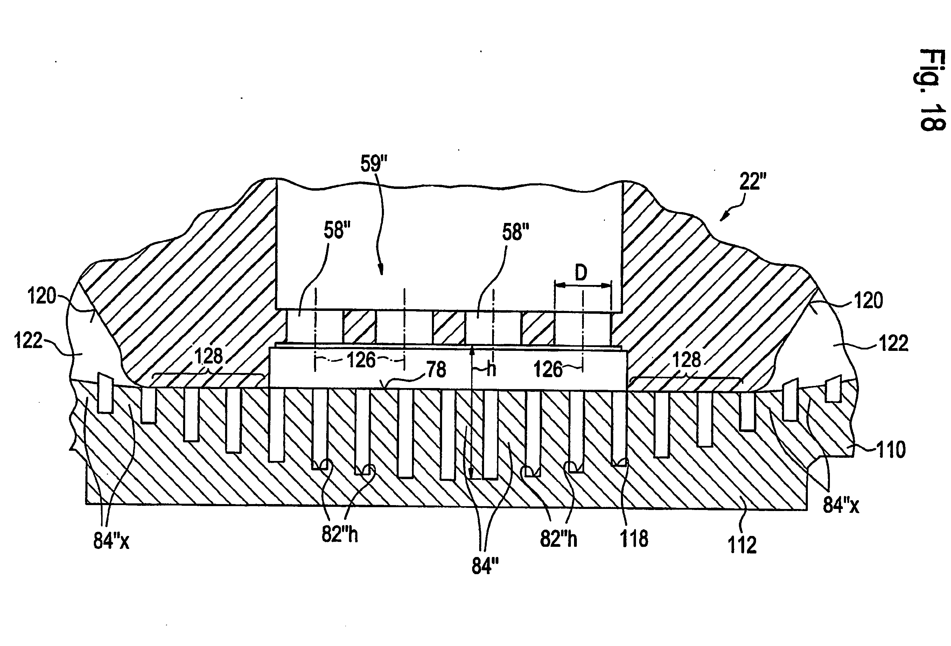

Das Wärmeaufnehmerteil 68" hat auf seiner in Fig. 17 und 18 oberen Seite eine muldenförmige Ausnehmung 118, beim vorliegenden Ausführungsbeispiel nach Art einer Kugelkalotte. Das Oberteil 22" hat eine ringförmige Ausnehmung 120, welche dem äußeren Abschnitt der Ausnehmung 118 gegenüber liegt und zusammen mit diesem Abschnitt einen Ringkanal 122 bildet, dessen Querschnitt etwa linsenförmig ist und der mit dem Abflussstutzen 62" in direkter Flüssigkeitsverbindung steht.

An der in Fig. 18 tiefsten Stelle der Kugelkalotte 118 befinden sich die Kühlkörper 84", die in den Fig. 16 und 18 stark vergrößert dargestellt sind. Ein Teil der Kühlkörper 84" befindet sich in Fig. 18 direkt unterhalb der Düsenplatte 59". Wie in Fig. 18 dargestellt, hat der Abstand von der Düsenplatte 59" zum Boden 82" der Kugelkalotte 118 einen Wert h, dessen optimale Größe sich aus Gleichung (3) ergibt und bevorzugt unterhalb von 5 mm liegt. Beim Ausführungsbeispiel hat h einen optimierten Wert von etwa 2,5 mm.

Die Längsachsen 126 der Düsen 58" verlaufen bevorzugt durch die Mittelebenen der Täler 82"h, vgl. die Fig. 16 und 18. Dies ermöglicht eine besonders gute Kühlung, weil das Kühlfluid dann direkt von oben in diese Täler einströmt und an deren Boden eine Prallkühlung mit hohem Wärmeübertragungskoeffizienten bewirkt.

Radial außerhalb derjenigen Kühlkörper 84", welche direkt unterhalb der Düsenplatte 59" liegen, liegt gegen dortige Kühlkörper 84" ein ringartiger Vorsprung 128 des Oberteils 22" an, so dass das Kühlfluid im Betrieb nicht über die dortigen Kühlkörper 84" hinweg strömen kann, sondern durch die Täler 82" zwischen ihnen strömen muss. Dies verhindert, dass sich kaltes und warmes Kühlfluid durchmischen, was die Effizienz der Kühlung reduzieren würde.

Radial außerhalb des ringartigen Vorsprungs 128 befinden sich Kühlkörper 84"x, deren Höhe nach außen ansteigt, was dort die Wärmeübertragung zusätzlich verbessert.

Wie man besonders gut an Fig. 17 erkennt, hat der Ringkanal 122 einen großen Querschnitt, so dass der Strömungswiderstand für das Kühlfluid, das durch den Zufluss 56" in Richtung des Pfeiles 36 (Fig. 17) zuströmt, in allen Himmelsrichtungen nur wenig differiert. Die Kühlung im Zentrum, also unterhalb der Düsenplatte 59", ist besonders gut, da das Kühlfluid dort am kältesten ist und längs der Linien 126 (Fig. 18) direkt zwischen die Kühlkörper 84" strömt und den Boden der Kugelkalotte 118 direkt kühlt, was die Kühlung im Zentrum des zu kühlenden Objekts (32 in Fig. 15) optimiert.

Auf der Oberseite des Oberteils 22" sind Verstärkungsrippen 130 vorgesehen, teils, um die mechanische Steifigkeit des Oberteils 22" zu erhöhen, teils, um diesem ein gefälliges, seine Herkunft kennzeichnendes Aussehen zu gehen.

Wie man in Fig. 17 besonders gut erkennt, erstreckt sich die Kugelkalotte 118 sowohl in den kreiszylindrischen Vorsprung 110, wie auch in den rechteckförmigen Vorsprung 112, d. h. die Kugelkalotte 118 erstreckt sich durch die Öffnung 115 der Platte 114 bis ganz nahe an die in Fig. 17 und 18 untere Stirnfläche 112u des Vorsprungs 112, was für die Wärmeübertragung von diesem Vorsprung 112 zum Kühlfluid in der Kugelkalotte 118 von großem Vorteil ist.

Im Rahmen der vorliegenden Erfindung sind vielfache Abwandlungen und Modifikationen möglich. Z. B. kann der Wärmeaufnehmer auch in umgekehrter Richtung vom Kühlfluid durchströmt werden, etwa dann, wenn das zu kühlende Substrat 34 in seinen äußeren Bereichen stärker gekühlt werden soll als in seinen zentralen Bereichen. Solche und ähnliche Modifikationen liegen im Rahmen des fachmännischen Tuns.


**Patentansprüche**

1. Wärmeaufnehmer zur Aufnahme von Wärme aus einem Bauteil (32) und zur Wärmeabfuhr mittels eines Kühlfluids (36),
   welcher Wärmeaufnehmer aufweist:

   Ein Formstück (22"), an welchem mindestens ein Zufuhrelement (56") zur Zufuhr von Kühlfluid (36) und mindestens ein Abfuhrelement (62") zur Abfuhr von Kühlfluid (36) vorgesehen ist;
   eine Wärmesenke (68"), welche eine Wärmeaufnahmeseite (112u) aufweist, die im Betrieb zur Aufnahme von Wärme dient,
   und welche eine Kühlfluidseite laufweist, die im Betrieb mit dem Kühlfluid (36) in Kontakt steht und mit einer muldenförmigen Vertiefung (118) versehen ist, in welcher eine Mehrzahl von Wärmeleitelementen (84") angeordnet sind, welche an ihren der muldenförmigen Vertiefung (118) zugewandten Enden mit dieser Vertiefung (118) wärmeleitend verbunden sind, und deren freie Enden von der muldenförmigen Vertiefung (118) weg ragen;
   mindestens einen auf der Wärmeaufnahmeseite der Wärmesenke (68") vorgesehenen Vorsprung (110, 112), in den sich von der Kühlfluidseite her die muldenförmige Vertiefung (118) erstreckt;
   und ein Halteglied (114), das eine Ausnehmung (115) aufweist,
   in welche der mindestens eine Vorsprung (110,112) der Wärmesenke (68") ragt, und das mit dem Formstück (22") verbunden ist, um die Wärmesenke (68") am Formstück (22") fest zu halten.

2. Wärmeaufnehmer nach Anspruch 1, bei welchem das Formstück (22") eine Ausnehmung (46") aufweist, in welche die Wärmesenke (68") ragt, wobei zwischen der Wärmesenke (68") und der Ausnehmung (46") mindestens ein Dichtglied (74") vorgesehen is.

3. Wärmeaufnehmer nach Anspruch 1 oder 2, bei welchem sich die muldenförmige Vertiefung (118) der Wärmesenke (68") durch die Ausnehmung (115) des Halteglieds (114) erstreckt und durch die Wärmeaufnahmeseite (112u) der Wärmesenke (68") flüssigkeitsdicht verschlossen ist.

4. Wärmeaufnehmer nach einem der vohengehendhen Ansprüche, bei welchem das Formstück (22") mit Befestigungsausnehmungen (117) versehen ist, welche hohle Fortsätze (117A) aufweisen, die das Halteglied (114) und dessen Befestigungselemente (116) überragen.

5. Wärmeaufnehmer nach Anspruch 4, bei welchem die Befestigungsausnehmungen (117) mindestens teilweise an seitlichen Vorsprüngen (119) des Formstücks (22") vorgesehen sind.

6. Wärmeaufnehmer nach einem der vorhergehenden Ansprüche, bei welchem das Zufuhrelement (56") dazu ausgebildet ist, der muldenförmigen Vertiefung (118) Kühlfluid im Bereich von deren tiefsten Stelle zuzuführen, und dazu mindestens eine Austrittsöffnung (58") aufweist, die in einem vorgegebenen Mindest-Abstand von den freien Enden (78) der Wärmeleitelemente (84") angeordnet ist.

7. Wärmeaufnehmer nach Anspruch 6, welchem im Bereich des Austritts des Kühlfluids (36) aus dem Zufuhrelement (56") ein Düsenfeld (59") angeordnet ist.

8. Wärmeaufnehmer nach Anspruch 6 oder 7, bei welches das Düsenfeld (59") einen Abstand (h) vom Boden (82") der muldenförmigen Vertiefung (118) aufweist, der bei Runddüsen (58"), welche einen vorgegebenen Durchmesser (D) haben, größer ist als dieser Durchmesser (D).

9. Wärmeaufnehmer nach Anspruch 8, bei welchem dieser Abstand (h) eine Größe hat, die etwas das zwei- bis dreifache dieses Durchmessers (D) beträgt.

10. Wärmeaufnehmer nach einem der vorhergehenden Ansprüche, bei welchem die muldenförmige Vertiefung (118) nach Art einer Kugelkalotte ausgebildet ist.

11. Wärmeaufnehmer nach einem der vorhergehenden Ansprüche, bei welchem die Wärmeleitelemente (84") nach Art von Stiften, Säulen, Rippen oder dgl. ausgebildet sind.

12. Wärmeaufnehmer nach einem der vorhergehenden Ansprüche, bei welchem zur Abfuhr des im Bereich der muldenförmigen Vertiefung (118) im Betrieb erwärmten Kühlfluids (64) um diese Vertiefung herum ein Ringkanal (122) vorgesehen ist, der mit einem Abfuhrelement (62") für das Kühlfluid verbunden ist.

13. Wärmeaufnehmer nach einem der vorhergehenden Ansprüche, bei welchem das mindestens eine Zufuhrelement (56") und das mindestens eine Abfuhrelement (62") am Formstück (22") angeordnet sind.

14. Wärmeaufnehmer nach einem der vorhergehenden Ansprüche, bei welchem das Formstück (22") als Spritzgussteil ausgebildet ist.

15. Wärmeaufnehmer nach einem der vorhergehenden Ansprüche, bei welchem den in der muldenförmigen Vertiefung (118) angeordneten Wärmeleitelementen (84") gegenüberliegend mindestens ein Strömungsleitkörper (128) vorgesehen ist, welcher im Zusammenwirken mit den Wärmeleitelementen (84") an verschiedenen Stellen der Wärmesenke (68") verschiedene Strömungswiderstände für ein Kühlfluid (36) definiert.

16. Wärmeaufnehmer nach Anspruch 15, bei welchem der Vorsprung (128) nach Art eines Ringes ausgebildet ist.

17. Wärmeaufnehmer nach Anspruch 16, bei welchem der Ring (128) um die Zufuhröffnung (56") für das Kühlfluid (36) herum angeordnet ist.

18. Wärmeaufnehmer nach einem der vorhergehenden Ansprüche, bei welchem das Zufuhrelement (56") zentral vorgesehen ist, um der Wärmesenke (68") etwa in deren Mitte Kühlfluid (36) zuzuführen und das Abfuhrelement (62") an einer Stelle an der Peripherie der muldenförmigen Vertiefung (118) mündet.

19. Wärmeaufnehmer nach einem der vorhergehenden Ansprüche, bei welchem im Bereich der Austrittsöffnung ein Düsenfeld (59") mit Düsen (58") angeordnet ist, welche so angeordnet sind, dass ein aus einer Düse (58") austretender Strahl (36") von Kühlfluid auf eine Stelle (82"cr) zwischen zwei benachbarten Wärmeleitelementen (84") gerichtet ist.

20. Wärmeaufnehmer nach Anspruch 19, bei welchem die Breite (d) der , Kühlkanäle (82"h, 82"v) zumindest überwiegend im Bereich von 0,2 bis 0,4 mm liegt.

21. Wärmeaufnehmer nach Anspruch 20, bei welchem eine Düse (58") so angeordnet ist, dass ein aus ihr austretender Strahl (36") von Kühlfluid auf eine Stelle (82"cr) zwischen vier benachbarten Wärmeleitelementen (84") gerichtet ist.

22. Wärmeaufnehmer nach einem der Ansprüche 19 bis 21, bei welchem die Wärmeleitelemente (84") nach Art von Nadeln ausgebildet sind, welche einen mittleren Querschnitt aufweisen und durch Vertiefungen nach Art von Tälern (82"h, 82"v) voneinander getrennt sind, deren lichte Weite (d) in einem Bereich liegt, der gegeben ist durch

$$d = (0{,}25 \text{ bis } 0{,}5) * \exp(0{,}5 * \ln Q),$$

wobei
d = lichte Weite eines Tals in mm
Q = mittlerer Querschnitt eines Wärmeleitelements (84") in mm$^2$;
ln = natürlicher Logarithmus; Logarithmus zur Basis e

23. Wärmeaufnehmer nach einem der vorhergehenden Ansprüche bei welchem das Halteglied (114) mechanisch mit dem Zufuhrelement (56") verbunden ist und die Wärmesenke (68") in einem Bereich außerhalb des Vorsprungs (110, 112) mechanisch abstützt.

24. Wärmeaufnehmer nach einem der vorhergehenden Ansprüche, bei welchem die Längsachse (64) des mindestens einen Abfuhrelements (62") einen Winkel ($\alpha$) von etwa 70° mit einer Ebene einschließt, die senkrecht zur Längsachse des Zufuhrelements (56") verläuft.

25. Wärmeaufnehmer nach einem der vorhergehenden Ansprüche, bei welchem das Formstück (22") aus Kunststoff ausgebildet ist.


**Claims**

1. Heat-absorber for absorbing heat from a component (32) and for discharging heat by means of a cooling fluid (36); which heat-absorber has:

   - a shaped piece (22") on which there are provided at least one infeed element (56") for feeding in cooling fluid (36) and at least one discharging element (62") for discharging cooling fluid (36);
   - a heat sink (68") which has a heat-absorbing side (112u) which serves to absorb heat during operation, and which has a cooling fluid side which is in contact with the cooling fluid (36) during operation and is provided with a trough-shaped depression (118) in which there are arranged a plurality of heat-conducting elements (84") which are connected to the trough-shaped depression (118) in a heat-conducting manner at their ends that face towards said depression (118), and whose free ends protrude away from the trough-shaped depression (118);
   - at least one projection (110, 112) which is provided on the heat-absorbing side of the heat sink (68") and into which the trough-shaped depression (118) extends from the cooling fluid side;
   - and a holding member (114) which has a clearance (115) into which the at least one projection (110, 112) on the heat sink (68") protrudes, and which holding member is connected to the shaped piece (22") in order to hold the heat sink (68") fast on the shaped piece (22").

2. Heat-absorber according to claim 1, in which the shaped piece (22") has a clearance (46") into which the heat sink (68") protrudes, at least one sealing member (74") being provided between the heat sink (68") and the clearance (46").

3.  Heat-absorber according to claim 1 or 2, in which the trough-shaped depression (118) in the heat sink (68") extends through the clearance (115) in the holding member (114) and is sealed in a fluid-tight manner by the heat-absorbing side (112u) of the heat sink (68").

4.  Heat-absorber according to one of the preceding claims, in which the shaped piece (22") is provided with fastening clearances (117) which have hollow extensions (117A) which protrude above the holding member (114) and its fastening elements (116).

5.  Heat-absorber according to claim 4, in which the fastening clearances (117) are provided, at least in some cases, on lateral projections (119) on the shaped piece (22").

6.  Heat-absorber according to one of the preceding claims, in which the infeed element (56") is constructed for the purpose of feeding cooling fluid to the trough-shaped depression (118) in the region of the lowest point on the latter; and has, for that purpose, at least one outlet aperture (58") which is arranged at a predetermined minimum distance from the free ends (78) of the heat-conducting elements (84").

7.  Heat-absorber according to claim 6, in which a nozzle array (59") is arranged in the region of the outlet of the cooling fluid (36) from the infeed element (56").

8.  Heat-absorber according to claim 6 or 7, in which the nozzle array (59") is at a distance (h) from the bottom (82") of the trough-shaped depression (118) which, in the case of round nozzles (58") which have a predetermined diameter (D), is greater than the said diameter (D).

9.  Heat-absorber according to claim 8, in which the magnitude of this distance (h) is approximately two to three times the said diameter (D).

10. Heat-absorber according to one of the preceding claims, in which the trough-shaped depression (118) is constructed in the manner of a spherical cap.

11. Heat-absorber according to one of the preceding claims, in which the heat-conducting elements (84") are constructed in the manner of pins, columns, ribs or the like.

12. Heat-absorber according to one of the preceding claims, in which, for the purpose of discharging the cooling fluid (64) which is heated up in the region of the trough-shaped depression (118) during operation, there is provided, around the said depression, an annular duct (122) which is connected to a discharging element (62") for the cooling fluid.

13. Heat-absorber according to one of the preceding claims, in which the at least one infeed element (56") and the at least one discharging element (62") are arranged on the shaped piece (22").

14. Heat-absorber according to one of the preceding claims, in which the shaped piece (22") is manufactured as an injection-moulded part.

15. Heat-absorber according to one of the preceding claims, in which there is provided, opposite the heat-conducting elements (84") arranged in the trough-shaped depression (118), at least one flow-conducting body (128) which, in cooperation with the heat-conducting elements (84"), defines various flow resistances for a cooling fluid (36) at various points in the heat sink (68").

16. Heat-absorber according to claim 15, in which the projection (128) is constructed in the manner of a ring.

17. Heat-absorber according to claim 16, in which the ring (128) is arranged around the infeed aperture (56") for the cooling fluid (36).

18. Heat-absorber according to one of the preceding claims, in which the infeed element (56") is provided centrally in order to feed cooling fluid (36) to the heat sink (68") approximately in the centre of the latter, and the discharging element (62") opens out at a point on the periphery of the trough-shaped depression (118).

19. Heat-absorber according to one of the preceding claims, in which there is arranged, in the region of the outlet aperture, a nozzle array (59") with nozzles (58") which are arranged in such a way that a jet (36") of cooling fluid passing out of a nozzle (58") is directed at a point (82"cr) between two adjacent heat-conducting elements (84").

20. Heat-absorber according to claim 19, in which the width (d) of the cooling ducts (82"h, 82"v) lies, at least predominantly, in the range from 0.2 to 0.4 mm.

21. Heat-absorber according to claim 20, in which one nozzle (58") is arranged in such a way that a jet (36") of cooling fluid passing out of it is directed at a point (82"cr) between four adjacent heat-conducting elements (84").

22. Heat-absorber according to one of claims 19 to 21, in which the heat-conducting elements (84") are constructed in the manner of needles which have an average cross-section and are separated from one another by depressions in the manner of troughs (82"h, 82"v) whose clear width (d) lies in a range which is supplied by

$$d = (0.25 \text{ to } 0.5) * \exp (0.5 * \ln Q),$$

where
d = clear width of a trough in mm;
Q = average cross-section of a heat-conducting element (84") in mm$^2$; and
ln = natural logarithm; logarithm to the base of e.

23. Heat-absorber according to one of the preceding claims, in which the holding member (114) is connected mechanically to the infeed element (56") and supports the heat sink (68") mechanically in a region outside the projection (110, 112).

24. Heat-absorber according to one of the preceding claims, in which the longitudinal axis (64) of the at least one discharging element (62") forms an angle ($\alpha$) of about 70° with a plane which extends perpendicularly to the longitudinal axis of the infeed element (56").

25. Heat-absorber according to one of the preceding claims, in which the shaped piece (22) is manufactured from plastic.

**Revendications**

1. Absorbeur de chaleur destiné à absorber la chaleur d'un composant (32) et évacuer la chaleur au moyen d'un fluide de refroidissement (36),
lequel absorbeur de chaleur présente :

une pièce préformée (22") sur laquelle au moins un élément d'amenée (56") pour amener le fluide de refroidissement (36) et au moins un élément d'évacuation (62") pour évacuer le fluide de refroidissement (36) sont prévus ;
un dissipateur de chaleur (68"), lequel présente un côté absorption de chaleur (112u) qui sert à absorber la chaleur en fonctionnement,
et lequel présente un côté fluide de refroidissement qui est en contact avec le fluide de refroidissement (36) en fonctionnement et qui est pourvu d'un renfoncement en forme d'auge (118) dans lequel est disposée une pluralité d'éléments thermoconducteurs (84"), dont les extrémités tournées vers le renfoncement en forme d'auge (118) sont reliés de manière thermoconductrice à ce renfoncement (118) et dont les extrémités libres font saillie du renfoncement en forme d'auge (118) ;
au moins une saillie (110, 112) prévue du côté absorption de chaleur du dissipateur de chaleur (68") dans laquelle le renfoncement en forme d'auge (118) s'étend depuis le côté fluide de refroidissement ;
et un organe de maintien (114) qui présente un évidement (115) dans lequel pénètre ladite au moins une saillie (110, 112) du dissipateur de chaleur (68") et qui est relié à la pièce préformée (22") pour maintenir le dissipateur de chaleur (68") sur la pièce préformée (22").

2. Absorbeur de chaleur selon la revendication 1, dans lequel la pièce préformée (22") présente un évidement (46") dans lequel pénètre le dissipateur de chaleur (68"), au moins un organe d'étanchéité (74") étant prévu entre le dissipateur de chaleur (68") et l'évidement (46").

**3.** Absorbeur de chaleur selon la revendication 1 ou 2, dans lequel le renfoncement en forme d'auge (118) du dissipateur de chaleur (68") s'étend à travers l'évidement (115) de l'organe de maintien (114) et est fermé de manière étanche aux liquides par le côté absorption de chaleur (112u) du dissipateur de chaleur (68").

**4.** Absorbeur de chaleur selon une des revendications précédentes, dans lequel la pièce préformée (22") est pourvue d'évidements de fixation (117), lesquels présentent des prolongements creux (117A) qui dépassent de l'organe de maintien (114) et de ses éléments de fixation (116).

**5.** Absorbeur de chaleur selon la revendication 4, dans lequel les évidements de fixation (117) sont prévus au moins partiellement sur des saillies latérales (119) de la pièce préformée (22").

**6.** Absorbeur de chaleur selon une des revendications précédentes, dans lequel l'élément d'amenée (56") est conçu pour amener du fluide de refroidissement au renfoncement en forme d'auge (118) dans la zone de son point le plus bas, et présente à cet effet au moins une ouverture de sortie (58") qui est disposée à une distance minimale prédéfinie des extrémités libres (78) des éléments thermoconducteurs (84").

**7.** Absorbeur de chaleur selon la revendication 6, dans lequel un champ de buses (59") est disposé au niveau de la sortie du fluide de refroidissement (36) de l'élément d'amenée (56").

**8.** Absorbeur de chaleur selon la revendication 6 ou 7, dans lequel le champ de buses (59") présente une distance (h) par rapport au fond (82") du renfoncement en forme d'auge (118) qui, dans le cas de buses rondes (58") ayant un diamètre prédéfini (D), est supérieure à ce diamètre (D).

**9.** Absorbeur de chaleur selon la revendication 8, dans lequel cette distance (h) a une valeur qui est environ égale à deux à trois fois ce diamètre (D).

**10.** Absorbeur de chaleur selon une des revendications précédentes, dans lequel le renfoncement en forme d'auge (118) est formé à la manière d'une calotte sphérique.

**11.** Absorbeur de chaleur selon une des revendications précédentes, dans lequel les éléments thermoconducteurs (84") sont formés à la manière de broches, colonnes, ailettes ou analogues.

**12.** Absorbeur de chaleur selon une des revendications précédentes, dans lequel, pour évacuer le fluide de refroidissement (64) réchauffé en fonctionnement dans la zone du renfoncement en forme d'auge (118), il est prévu un canal annulaire (112) autour de ce renfoncement, qui est relié à un élément d'évacuation (62") pour le fluide de refroidissement.

**13.** Absorbeur de chaleur selon une des revendications précédentes, dans lequel ledit au moins un élément d'amenée (56") et ledit au moins un élément d'évacuation (62") sont disposés sur la pièce préformée (22").

**14.** Absorbeur de chaleur selon une des revendications précédentes, dans lequel la pièce préformée (22") est réalisée sous la forme d'une pièce moulée par injection.

**15.** Absorbeur de chaleur selon une des revendications précédentes, dans lequel il est prévu au moins un corps de guidage de courant (128) en face des éléments thermoconducteurs (84") disposés dans le renfoncement en forme d'auge (118), lequel définit, en coopération avec les éléments thermoconducteurs (84"), différentes résistances à l'écoulement pour un fluide de refroidissement (36) à différents endroits du dissipateur de chaleur (68").

**16.** Absorbeur de chaleur selon la revendication 15, dans lequel la saillie (128) est formée à la manière d'un anneau.

**17.** Absorbeur de chaleur selon la revendication 16, dans lequel l'anneau (128) est disposé autour de l'ouverture d'amenée (56") pour le fluide de refroidissement (36).

**18.** Absorbeur de chaleur selon une des revendications précédentes, dans lequel l'élément d'amenée (56") est prévu en position centrale, pour amener du fluide de refroidissement (36) au dissipateur de chaleur (68") à peu près en son centre et l'élément d'évacuation (62") débouche à un endroit situé à la périphérie du renfoncement en forme d'auge (118).

**19.** Absorbeur de chaleur selon une des revendications précédentes, dans lequel un champ de buses (59") avec des buses (58") est disposé dans la zone de l'ouverture de sortie, lesquelles buses (58") sont disposées de façon qu'un jet (36") de fluide de refroidissement sortant d'une buse (58") soit dirigé sur un endroit (82"cr) situé entre deux éléments thermoconducteurs (84") adjacents.

**20.** Absorbeur de chaleur selon la revendication 19, dans lequel la largeur (d) des canaux de refroidissement (82"h, 82"v) se situe au moins principalement dans la plage comprise entre 0,2 et 0,4 mm.

**21.** Absorbeur de chaleur selon la revendication 20, dans lequel une buse (58") est disposée de façon qu'un jet (36") de fluide de refroidissement sortant d'elle soit dirigé sur un endroit (82"cr) situé entre quatre éléments thermoconducteurs (84") adjacents.

**22.** Absorbeur de chaleur selon une des revendications 19 à 21, dans lequel les éléments thermoconducteurs (84") sont formés à la manière d'aiguilles qui présentent une section moyenne et sont séparées les unes des autres par des renfoncements à la manière de vallées (82"h, 82"v) dont la largeur intérieure (d) se situe dans une plage qui est donnée par

$$d = (0{,}25 \text{ à } 0{,}5) * \exp(0{,}5 * \ln Q),$$

avec
d = largeur intérieure d'une vallée en mm
Q = section moyenne d'un élément thermoconducteur (84") en mm$^2$;
ln = logarithme naturel ; logarithme en base e

**23.** Absorbeur de chaleur selon une des revendications précédentes, dans lequel l'organe de maintien (114) est relié mécaniquement à l'élément d'amenée (56") et soutient mécaniquement le dissipateur de chaleur (68") dans une zone située à l'extérieur de la saillie (110, 112).

**24.** Absorbeur de chaleur selon une des revendications précédentes, dans lequel l'axe longitudinal (64) dudit au moins un élément d'évacuation (62") fait un angle ($\alpha$) d'environ 70° avec un plan qui s'étend perpendiculairement à l'axe longitudinal de l'élément d'amenée (56").

**25.** Absorbeur de chaleur selon une des revendications précédentes, dans lequel la pièce préformée (22") est réalisée en matière plastique.

Fig. 1

# Fig. 2

Fig. 3

EP 1 728 278 B1

Fig. 4

# Fig. 5

## Fig. 6

EP 1 728 278 B1

## Fig. 7

22

## Fig. 8

Fig. 9

## Fig. 10

58

59

58

58

Fig. 11

## Fig. 12

Fig. 13

## Fig. 14

Fig. 15

## Fig. 16

Fig. 17

XVI

XVIII

20"

36

56"

59"

58"

62"

64"

α

130

46" 74"

120

130

22"

130

117A

116 114 118 115

128 84" 112u 112

110

68" 74"

116 117A

122 122

EP 1 728 278 B1

Fig. 18

EP 1 728 278 B1

Fig. 19

Fig. 20

**EP 1 728 278 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5263536 A
- US 5070936 A

- JP 6244575 A